# EUROPÄISCHE PATENTSCHRIFT

(11) **EP 2 162 928 B1**
(45) Veröffentlichungstag und Bekanntmachung des Hinweises auf die Patenterteilung: **11.04.2018**
(21) Anmeldenummer: 08773269.9
(22) Anmeldetag: 19.06.2008
(51) Int. Cl.: H01L 33/00, H01L 33/38, H01L 33/62, H01L 25/075

(54) **VERFAHREN ZUR HERSTELLUNG EINER MEHRZAHL OPTOELEKTRONISCHER BAUELEMENTE UND OPTOELEKTRONISCHES BAUELEMENT**
METHOD FOR THE PRODUCTION OF A PLURALITY OF OPTOELECTRONIC COMPONENTS, AND OPTOELECTRONIC COMPONENT
PROCÉDÉ DE RÉALISATION D'UNE PLURALITÉ DE COMPOSANTS OPTO-ÉLECTRONIQUES ET COMPOSANT OPTO-ÉLECTRONIQUE

(30) Priorität: 29.06.2007 DE 102007030129
(43) Veröffentlichungstag der Anmeldung: 17.03.2010
(73) Patentinhaber: OSRAM Opto Semiconductors GmbH, 93055 Regensburg (DE)
(72) Erfinder: HERRMANN, Siegfried, 94362 Neukirchen (DE)
(74) Vertreter: Epping - Hermann - Fischer
(86) Internationale Anmeldenummer: PCT/DE2008/001008
(87) Internationale Veröffentlichungsnummer: WO 2009/003442

(56) Entgegenhaltungen:
- EP-A2- 1 653 523
- WO-A-2007/016908
- DE-A1- 10 017 336
- JP-A- 2006 278 766
- US-A1- 2006 006 404
- US-A1- 2006 231 853
- US-A1- 2007 096 130
- US-A1- 2007 126 016

## Beschreibung

Die vorliegende Erfindung betrifft ein Verfahren zur Herstellung einer Mehrzahl optoelektronischer Bauelemente gemäß Anspruch 1 und ein optoelektronisches Bauelement gemäß Anspruch 9. Das Dokument JP 2006 278766 A (SEIKO EPSON CORP) veröffentlicht am 12. Oktober 2006 offenbart ein LED-Bauelement mit einer Verdrahtungsschicht auf einer ansteigenden Isolationsschicht und dessen Herstellungsverfahren.

Für die Herstellung von optoelektronischen Bauelementen, die nach der Herstellung auf einem elektrischen Leiterträger, wie zum Beispiel einer Leiterplatte, befestigt und elektrisch kontaktiert werden sollen, sind oftmals eine Reihe von Einzelbearbeitungsschritten, welche an jedem Bauelement einzeln durchgeführt werden müssen, erforderlich. Beispielsweise werden optoelektronische Halbleiterchips mittels eines so genannten Pick and Place-Verfahrens einzeln in Gehäuse für die jeweils herzustellenden Bauelemente eingebracht und jeweils einzeln mit Anschlussleitern des Gehäuses elektrisch leitend verbunden. Einzelbearbeitungsschritte, also Schritte, die für jedes Bauelement gesondert durchgeführt werden, sind jedoch im Vergleich zu Bearbeitungsschritten, welche gleichzeitig für eine Vielzahl von Bauelementen durchgeführt werden können, kostenintensiv und aufwändig.
Eine Aufgabe der vorliegenden Erfindung ist es, ein vereinfachtes Verfahren zur Herstellung einer Mehrzahl optoelektronischer Bauelemente sowie ein optoelektronisches Bauelement anzugeben, welches vereinfacht herstellbar ist.
Diese Aufgabe wird durch ein Verfahren beziehungsweise ein optoelektronisches Bauelement gemäß den unabhängigen Patentansprüchen gelöst. Vorteilhafte Ausgestaltungen und Weiterbildungen der Erfindung sind Gegenstand der abhängigen Patentansprüche.
In einem erfindungsgemäßen Verfahren zur Herstellung einer Mehrzahl optoelektronischer Bauelemente wird zunächst ein Anschlussträgerverbund bereitgestellt, der eine Mehrzahl von Bauelementbereichen aufweist, wobei in den Bauelementbereichen jeweils zumindest ein elektrischer Anschlussbereich vorgesehen ist. Weiterhin wird ein Halbleiterkörperträger bereitgestellt, auf dem eine Mehrzahl gesonderter und mit dem Halbleiterkörperträger verbundener Halbleiterkörper angeordnet ist, wobei die Halbleiterkörper jeweils eine Halbleiterschichtenfolge mit einem aktiven Bereich aufweisen.
Daraufhin werden der Anschlussträgerverbund und der Halbleiterkörperträger relativ zueinander derart angeordnet, dass die Halbleiterkörper den Bauelementbereichen zugewandt sind. Bevorzugt werden der Anschlussträgerverbund und der Halbleiterkörperträger derart angeordnet, insbesondere derart zueinander angeordnet, dass Halbleiterkörper mit dem Anschlussträgerverbund in mechanischen Kontakt treten. Halbleiterkörper können insbesondere auf dem Anschlussträgerverbund aufliegen.

Nachfolgend wird eine Mehrzahl von Halbleiterkörpern mit dem Anschlussträgerverbund in einem Montagebereich eines dem jeweiligen Halbleiterkörper zugeordneten Bauelementbereichs mechanisch verbunden. Der jeweilige Halbleiterkörper wird mit dem Anschlussbereich des dem Halbleiterkörper zugeordneten Bauelementbereichs elektrisch leitend verbunden. Die mit dem Anschlussträgerverbund, insbesondere elektrisch und/oder mechanisch, zu verbindenden oder bereits verbundenen Halbleiterkörper werden vom Halbleiterkörperträger getrennt. Das Trennen der Halbleiterkörper vom Halbleiterkörperträger kann also vor oder nach dem elektrischen und/oder mechanischen Verbinden des jeweiligen Halbleiterkörpers mit dem Anschlussträgerverbund erfolgen.

Daraufhin wird der Anschlussträgerverbund in eine Mehrzahl von gesonderten optoelektronischen Bauelementen aufgeteilt, wobei die Bauelemente jeweils einen Anschlussträger, der den Bauelementbereich aufweist, und einen auf dem Anschlussträger angeordneten und mit dem Anschlussbereich elektrisch leitend verbundenen Halbleiterkörper aufweisen.

Ein derartiges Verfahren hat den Vorteil, dass das elektrisch leitende Verbinden und das mechanische Verbinden von Halbleiterkörpern mit einem Anschlussbereich eines Anschlussträgers im Verbund erfolgen kann. Das elektrische und mechanische Verbinden der Halbleiterkörper kann demnach in einem Prozessschritt gleichzeitig an einer Mehrzahl von Halbleiterkörpern durchgeführt werden. Einzelbearbeitungsschritte, zum Beispiel ein Pick and Place-Prozess oder eine gesonderte, d.h. für jeden Halbleiterkörper einzeln auszuführende, Drahtbondverbindung, können verringert oder vermieden werden.

Zweckmäßigerweise werden Halbleiterkörper vom Halbleiterkörperträger getrennt und im Montagebereich mit dem Anschlussträgerverbund verbunden, die sich über den Montagebereich des jeweiligen Bauelementbereichs des Anschlussträgerverbundes erstrecken.

Der Anschlussträgerverbund und die Verteilung der Halbleiterkörper auf dem Halbleiterkörperträger sind vorzugsweise derart aufeinander abgestimmt, dass sich beim Anordnen des Anschlussträgerverbunds und des Halbleiterkörperträgers relativ zueinander in einer vorgegebenen Weise ein Halbleiterkörper, vorzugsweise genau ein Halbleiterkörper, über einen diesem Halbleiterkörper zugeordneten Montagebereich erstreckt.

Bevorzugt verbleiben Halbleiterkörper, welche sich nicht über einen Montagebereich des Anschlussträgerverbundes erstrecken, auf dem Halbleiterkörperträger. Es können also selektiv Halbleiterkörper, welche sich über Montagebereiche des Anschlussträgerverbundes erstrecken vom Halbleiterkörperträger getrennt werden, wohingegen sich nicht über Montagebereiche erstreckende Halbleiterkörper auf dem Halbleiterkörperträger verbleiben können. Dies hat den Vorteil, dass die Anordnung der Halbleiterkörper auf dem Halbleiterkörperträger nicht an die Anordnung der Montagebereiche angepasst sein muss oder umgekehrt.

Für das Herstellen der Mehrzahl von Bauelementen wird bevorzugt nur ein Teil der auf dem Halbleiterkörperträger angeordneten Halbleiterkörper von dem Halbleiterkörperträger getrennt und mit dem Anschlussträgerverbund verbunden.

In einer bevorzugten Ausgestaltung erfolgt das Trennen der Halbleiterkörper von dem Halbleiterkörperträger mittels elektromagnetischer Strahlung, insbesondere Laserstrahlung. Ein Lasertrennverfahren eignet sich besonders für das selektive Trennen einzelner Halbleiterkörper von dem Halbleiterkörperträger. Abzutrennende Halbleiterkörper können lokal mit einem Laser bestrahlt werden. Nicht bestrahlte Halbleiterkörper verbleiben auf dem Halbleiterkörperträger.

In einer bevorzugten Ausgestaltung werden die Halbleiterkörper vor dem Bereitstellen derart auf dem Halbleiterkörperträger angeordnet und befestigt, dass die Verteilung der Halbleiterkörper auf dem Halbleiterkörperträger der Verteilung der Montagebereiche des Anschlussträgerverbunds entspricht. Mit anderen Worten ausgedrückt, werden die Halbleiterkörper derart auf dem Halbleiterkörperträger angeordnet, dass sich die Halbleiterkörper, vorzugsweise alle Halbleiterkörper, bei der Anordnung des Anschlussträgerverbunds und des Halbleiterkörperträgers relativ zueinander über einen Montagebereich erstrecken. Dabei können alle Halbleiterkörper vom Halbleiterkörperträger getrennt und mit dem Anschlussträgerverbund verbunden werden.

In einer weiteren bevorzugten Ausgestaltung ist der Anschlussträgerverbund ein Anschlussträgerwafer. Der Anschlussträgerverbund ist hierzu insbesondere flächig ausgebildet. Bauelementbereiche können flächig, beispielsweise matrixartig, über den Anschlussträgerverbund verteilt sein.

In einer weiteren bevorzugten Ausgestaltung ist der Halbleiterkörperträger mit den darauf angeordneten Halbleiterkörpern ein Halbleiterwafer. Die Halbleiterkörper können flächig, zum Beispiel matrixartig, über den Halbleiterkörperträger verteilt sein.

In einer weiteren bevorzugten Ausgestaltung sind die Halbleiterkörper epitaktisch gewachsen. Weiterhin ist oder wird ein Aufwachssubstrat, auf dem die Halbleiterkörper gewachsen wurden, von den Halbleiterkörpern vorzugsweise entfernt. Der Halbleiterkörperträger kann das Aufwachssubstrat umfassen. Ist der Halbleiterkörper vom Aufwachssubstrat getrennt, so besteht der Halbleiterkörper zweckmäßigerweise aus epitaktisch gewachsenen Schichten. Das Trennen der Halbleiterkörper vom Aufwachssubstrat kann nach dem Verbinden der Halbleiterkörper mit dem Anschlussträgerverbund erfolgen. Mittels des Verfahrens können insbesondere reine Epitaxie-Schichten direkt auf einen Anschlussträgerverbund übertragen werden. Eine die Epitaxieschichten stabilisierende Schicht, wie zum Beispiel ein Chipsubstrat bei herkömmlichen Halbleiterchips, welche im Rahmen des Pick and Place-Verfahrens in einem Gehäuse montiert werden, ist nicht erforderlich. Die Bauelementhöhe kann so reduziert werden.

In einer weiteren bevorzugten Ausgestaltung ist auf den Halbleiterkörpern eine Spiegelschicht angeordnet. Die Spiegelschicht kann ein Metall oder eine Metallverbindung enthalten oder daraus bestehen. Die Spiegelschicht ist vorzugsweise auf den Halbleiterkörpern abgeschieden. Die Halbleiterkörper können mit auf den Halbleiterkörpern angeordneter Spiegelschicht auf dem Halbleiterkörperträger bereitgestellt werden. Die Spiegelschicht kann auf der dem Anschlussträgerverbund zugewandten Seite des Halbleiterkörpers oder zwischen dem Halbleiterkörper und dem Halbleiterkörperträger angeordnet sein.

In einer weiteren bevorzugten Ausgestaltung ist der aktive Bereich zur Erzeugung von Strahlung, vorzugsweise sichtbarer Strahlung, geeignet und insbesondere vorgesehen. Die Spiegelschicht ist zweckmäßigerweise reflektierend für die im aktiven Bereich zu erzeugende Strahlung ausgebildet.

In einer weiteren bevorzugten Ausgestaltung wird nach dem Verbinden der Halbleiterkörper mit dem Anschlussträgerverbund und/oder nach dem Trennen der Halbleiterkörper von dem Halbleiterkörperträger ein weiterer Prozessschritt an den Halbleiterkörpern durchgeführt. Dieser Prozessschritt wird vorzugsweise vor dem Aufteilen des Anschlussträgerverbundes in optoelektronische Bauelemente durchgeführt. Beispielsweise kann eine Auskoppelstruktur auf oder in den Halbleiterkörpern ausgebildet werden. Der jeweilige Halbleiterkörper, insbesondere eine Strahlungsdurchtrittsfläche des Halbleiterkörpers, zum Beispiel für die Auskopplung von Strahlung aus dem Halbleiterkörper, kann für eine Auskoppelstruktur beispielsweise aufgeraut werden. Ferner kann eine Passivierungsschicht auf den jeweiligen Halbleiterkörper aufgebracht werden.

In einer weiteren bevorzugten Ausgestaltung weist der jeweilige Anschlussbereich den Montagebereich und einen Anschlussleiterbereich, z. B. eine Anschlussleiterschicht, auf. Der jeweilige Halbleiterkörper kann also auf dem Anschlussbereich montiert sein.
Bevorzugt erhebt sich der Montagebereich über den Anschlussleiterbereich. Bei einem Aufliegen eines Halbleiterkörpers auf dem Montagebereich kann aufgrund der Erhebung vermieden werden, dass ein dem Halbleiterkörper benachbarter, auf dem Halbleiterkörperträger angeordneter Halbleiterkörper mit dem Anschlussbereich in mechanischen Kontakt tritt. Das selektive Abtrennen eines über dem Montagebereich angeordneten Halbleiterkörpers vom Halbleiterkörperträger wird so erleichtert.

Der Montagebereich kann beispielsweise durch eine Befestigungsschicht, z. B. eine Klebe- oder Lotschicht, gebildet sein. Weist der Anschlussbereich den Montagebereich auf, so ist die Befestigungsschicht bevorzugt elektrisch leitfähig ausgebildet. Die Befestigungsschicht kann bereichsweise auf einer Schicht für den Anschlussbereich, z. B. einer Anschlussleiterschicht, angeordnet sein. Die Befestigungsschicht kann beispielsweise als Lotschicht oder elektrisch leitfähig ausgebildete Klebeschicht ausgebildet sein.

In einer weiteren bevorzugten Ausgestaltung weist ein Bauelementbereich zwei elektrisch voneinander isolierte Anschlussbereiche auf. Diese Anschlussbereiche können mit dem Halbleiterkörper auf verschiedenen Seiten des aktiven Bereichs elektrisch leitend verbunden werden.

Der Halbleiterkörper ist vorzugsweise als strahlungsemittierender Halbleiterkörper, zum Beispiel als Lumineszenzdioden-Halbleiterkörper, ausgeführt.

In einer weiteren bevorzugten Ausgestaltung weist der Anschlussträgerverbund eine Anschlussträgerschicht auf, wobei auf der Anschlussträgerschicht eine Mehrzahl von Bauelementbereichen ausgebildet ist. Der Anschlussträger für das jeweilige Bauelement wird bevorzugt unter Zerteilen der Anschlussträgerschicht gebildet. Die Anschlussträgerschicht kann also für das Aufteilen des Anschlussträgerverbunds vereinzelt werden. Ein Anschlussträger ist zweckmäßigerweise aus einem Stück der Anschlussträgerschicht gebildet.

In einer weiteren bevorzugten Ausgestaltung weist der Anschlussträgerverbund eine Mehrzahl von gesonderten Anschlussträgern auf, die auf einer gemeinsamen Hilfsträgerschicht angeordnet sind. Für das Aufteilen des Anschlussträgerverbunds in optoelektronische Bauelemente wird die Hilfsträgerschicht vorzugsweise entfernt. Im Gegensatz zu einer durchgehenden Anschlussträgerschicht kann der Anschlussträgerverbund also gesonderte Anschlussträger aufweisen, die mittels einer Hilfsträgerschicht im Verbund gehalten werden können. Dabei kann ein Anschlussträger einem Bauelementbereich entsprechen.

In einer weiteren bevorzugten Ausgestaltung umfasst der Anschlussträger einen elektrisch isolierenden Trägerkörper und einen auf den Trägerkörper aufgebrachten Anschlussbereich. Der Anschlussbereich kann, zum Beispiel durch Aufdampfen oder Sputtern, auf dem Trägerkörper abgeschieden sein.

In einer weiteren bevorzugten Ausgestaltung enthält der Anschlussträger, insbesondere der Trägerkörper eine Keramik. Eine Keramik, zum Beispiel eine Aluminiumnitrid- oder eine Aluminiumoxid-Keramik, kann sich durch eine vorteilhaft hohe Wärmeleitfähigkeit auszeichnen.

In einer weiteren bevorzugten Ausgestaltung weist der Anschlussträger einen elektrisch leitfähigen Metallkörper oder einen Metallverbindungskörper auf. Ein Anschlussbereich kann durch eine Oberfläche des Metallverbindungskörpers gebildet sein. Für zwei Anschlussbereiche sind zweckmäßigerweise zwei gesonderte Metallkörper beziehungsweise - verbindungskörper miteinander verbunden und elektrisch voneinander isoliert.

In einer weiteren bevorzugten Ausgestaltung ist der Anschlussträger, insbesondere der Trägerkörper, als Wärmesenke ausgeführt oder ausgebildet. Eine Keramik, z. B. eine Aluminiumnitrid- oder Aluminiumoxid-Keramik, oder ein Metallkörper beziehungsweise ein Metallverbindungskörper sind aufgrund der hohen thermischen Leitfähigkeit dieser Materialien für eine Wärmesenke besonders geeignet.

In einer weiteren bevorzugten Ausgestaltung ist der Anschlussträger für im Halbleiterkörper erzeugte Strahlung durchlässig. Strahlung kann somit aus dem Halbleiterkörper in den Anschlussträger eintreten und über den Anschlussträger aus dem Bauelement ausgekoppelt werden. Der Anschlussträger kann hierzu beispielsweise ein Glas enthalten.

In einer weiteren bevorzugten Ausgestaltung werden die Anschlussbereiche des Anschlussträgerverbundes mittels Lithographie ausgebildet. Ein lithographisches Verfahren, wie beispielsweise Photolithographie, insbesondere Photolithographie unter Einsatz eines Lasers zum Belichten von Photolackmaterial, z. B. für eine Maskenstruktur, zeichnet sich dadurch aus, dass sehr feine Strukturen realisiert werden können. Dementsprechend können Bauelementbereiche entsprechend dicht angeordnet im Anschlussträgerverbund vorgesehen sein.

Die Anschlussbereiche können mittels Abscheidens, z. B. Sputterns oder Aufdampfens, auf dem Anschlussträger bzw. der Anschlussträgerschicht ausgebildet sein. Die Anschlussbereiche können nach dem Abscheiden galvanisch verstärkt werden.

In einer weiteren bevorzugten Ausgestaltung beträgt ein Abstand benachbarter Halbleiterkörper auf dem Halbleiterkörperträger 40 µm oder weniger, bevorzugt 30 µm oder weniger, besonders bevorzugt 20 µm oder weniger, z. B. 10 µm oder weniger oder 5 µm oder weniger. Derart geringe Abstände zwischen Halbleiterkörpern auf dem Halbleiterkörperträger können realisiert werden, da - im Gegensatz zur üblichen Fertigung von Halbleiterchips durch Zersägen eines Halbleiterwafers - der Halbleiterkörperträger vorliegend bevorzugt nicht zerteilt wird, sondern die Halbleiterkörper (selektiv) vom Halbleiterkörperträger abgetrennt und unmittelbar auf den Anschlussträgerverbund übertragen werden können. Es ist also nicht nötig, für das Zerteilen eines Halbleiterwafers zwischen den Halbleiterkörpern einen derart großen Abstand vorzusehen, dass diese beim Zertrennen des Halbleiterkörperträgers nicht beschädigt werden.

In einer weiteren bevorzugten Ausgestaltung werden die Halbleiterkörper vor dem Bereitstellen des Halbleiterkörperträgers mittels Ätzen, z. B. mittels eines Plasma-Ätzverfahrens, aus einer, insbesondere epitaktisch gewachsenen, Halbleiterschichtstruktur ausgebildet. Für das Erzielen von geringen Abständen zwischen benachbarten Halbleiterkörpern (siehe weiter oben) auf dem Halbleiterkörperträger hat sich ein Plasma-Ätzverfahren in Kombination mit einer entsprechenden Maske als besonders geeignet erwiesen.

In einer weiteren bevorzugten Ausgestaltung wird in einem Bauelementbereich eine Mehrzahl von Halbleiterkörpern mit dem Anschlussträgerverbund verbunden. Zweckmäßigerweise ist jedem dieser Halbleiterkörper ein Montagebereich, vorzugsweise jedem Halbleiterkörper ein gesonderter Montagebereich, und ein Anschlussbereich des Bauelementbereichs zugeordnet. Die Halbleiterkörper sind mit Vorzug nebeneinander angeordnet. Weiterhin umfasst ein optoelektronisches Bauelement vorzugsweise genau einen Bauelementbereich.

Ein Abstand benachbarter Halbleiterkörper im Bauelementbereich kann 40 µm oder weniger, bevorzugt 30 µm oder weniger, besonders bevorzugt 20 µm oder weniger, z. B. 10 µm oder weniger oder 5 µm oder weniger betragen. Halbleiterkörper können in den Bauelementbereich mit den Abständen übertragen werden, welche sie bereits auf dem Halbleiterkörperträger aufweisen. Der zwischen den Halbleiterkörpern erzielbare Abstand ist damit im Wesentlichen nur durch die Auflösung der bei der Ausbildung der Halbleiterkörper aus einer Halbleiterschichtstruktur eingesetzten Verfahren, z. B. einem (photo)lithographischen Verfahren, nach unten begrenzt.

Ein optoelektronisches Bauelement umfasst gemäß einer Ausführungsform einen Halbleiterkörper, der eine Halbleiterschichtenfolge mit einem aktiven Bereich umfasst.

In einer bevorzugten Ausgestaltung weist das Bauelement einen Anschlussträger auf, auf dem der Halbleiterkörper angeordnet und befestigt ist. Vorzugsweise ist auf der dem Halbleiterkörper zugewandten Seite des Anschlussträgers ein elektrischer Anschlussbereich ausgebildet. Der Anschlussbereich erstreckt sich weiterhin in Aufsicht auf den Anschlussträger bevorzugt neben dem Halbleiterkörper. Der Anschlussbereich kann in Aufsicht auf den Anschlussträger neben dem Halbleiterkörper angeordnet sein. Ferner ist der Anschlussbereich vorzugsweise mit dem Halbleiterkörper elektrisch leitend verbunden.

Das optoelektronische Bauelement ist bevorzugt in dem weiter oben beschriebenen Verfahren hergestellt, sodass sich weiter oben und im Folgenden für das Verfahren beschriebene Merkmale auch auf das optoelektronische Bauelement beziehen können, und umgekehrt. Ein Bauelementbereich des Anschlussträgerverbundes kann dabei dem Teil des Verbundes entsprechen, welcher das spätere Bauelement bildet.

In einer bevorzugten Ausgestaltung weist das Bauelement eine Planarisierungsschicht auf, die neben dem Halbleiterkörper auf dem Anschlussträger angeordnet ist. Zweckmäßigerweise ist ein Abstand der vom Anschlussträger abgewandten Seite der Planarisierungsschicht von der dem Anschlussträger abgewandten Seite des Halbleiterkörpers geringer als ein Abstand der vom Anschlussträger abgewandten Seite des Halbleiterkörpers von dem Anschlussträger.

Für das Ausbilden der Planarisierungsschicht wird nach dem Befestigen der Halbleiterkörper auf dem Anschlussträgerverbund bevorzugt ein Planarisierungsmaterial zwischen die Halbleiterkörper auf den Anschlussträgerverbund aufgebracht. Das Planarisierungsmaterial wird, insbesondere nach dem Aufbringen auf den Anschlussträgerverbund, zweckmäßigerweise derart ausgebildet, dass neben dem jeweiligen Halbleiterkörper eine Planarisierungsschicht angeordnet ist. Die Planarisierungsschicht kann sich dabei durchgehend über den Verbund erstrecken oder bereichsweise neben den jeweiligen Halbleiterkörpern ausgebildet sein. Das Planarisierungsmaterial ist vorzugsweise eine Formmasse. Das Planarisierungsmaterial kann insbesondere als Formmasse aufgebracht, zum Beispiel aufgeschleudert, und nachfolgend verfestigt werden. Als Planarisierungsmaterial eignet sich zum Beispiel ein BCB (Benzocyclobutene).

Dabei wird ein sich gegebenenfalls über die von den Montagebereichen abgewandte Seite der Halbleiterkörper erstreckender Teil des Planarisierungsmaterials für die Ausbildung der Planarisierungsschicht zweckmäßigerweise entfernt. Insgesamt kann mittels der Planarisierungsschicht erreicht werden, dass die vom Montagebereich abgewandte Fläche des Halbleiterkörpers eben in die vom Anschlussträger abgewandte Fläche der Planarisierungsschicht übergeht.

Eine weitergehende planare Prozessführung bei der Herstellung der optoelektronischen Bauelemente wird so erleichtert.
Vorzugsweise kann das (gesamte) Verfahren als planares Verfahren durchgeführt werden.

Das Planarisierungsmaterial und dementsprechend auch die Planarisierungsschicht sind vorzugsweise elektrisch isolierend. Weiterhin kann das Planarisierungsmaterial strahlungsdurchlässig für eine im Halbleiterkörper zu erzeugende Strahlung sein. Eine Absorption von Strahlung im Planarisierungsmaterial kann so vermieden werden.

Bevorzugt weist der Anschlussbereich des Bauelements einen Montagebereich und einen Anschlussleiterbereich auf, wobei der Halbleiterkörper besonders bevorzugt im Montagebereich auf dem Anschlussträger befestigt und insbesondere elektrisch leitend mit dem Anschlussbereich verbunden ist. Der Anschlussbereich kann insbesondere bereichsweise zwischen dem Anschlussträger und dem Halbleiterkörper angeordnet sein.

In einer weiteren bevorzugten Ausgestaltung wird nach dem Befestigen der Halbleiterkörper auf dem Anschlussträgerverbund und insbesondere noch vor dem Aufteilen des Anschlussträgerverbundes ein elektrischer Kontakt auf die von dem Montagebereich abgewandte Seite des jeweiligen Halbleiterkörpers aufgebracht.

In einer weiteren bevorzugten Ausgestaltung wird der Kontakt auf den Halbleiterkörper und die Planarisierungsschicht aufgebracht. Der elektrische Kontakt, der zweckmäßigerweise für die Kontaktierung der vom Anschlussträger abgewandten Seite des Halbleiterkörpers ausgebildet ist, kann sich also über die von dem Anschlussträger abgewandte Seite der Planarisierungsschicht erstrecken. Der Kontakt des jeweiligen Halbleiterkörpers kann mittels Abscheidens auf den Halbleiterkörper und insbesondere auch die Planarisierungsschicht aufgebracht, beispielsweise aufgedampft oder aufgesputtert, werden.

Der jeweilige Kontakt weist bevorzugt eine Stromverteilungsstruktur auf. Diese ist zweckmäßigerweise auf der vom Anschlussträger abgewandten Seite des Halbleiterkörpers angeordnet. Die Stromverteilungsstruktur kann auf die von dem Montagebereich des Halbleiterkörpers abgewandte Seite des jeweiligen Halbleiterkörpers aufgebracht werden. Die Stromverteilungsstruktur erstreckt sich vorzugsweise großflächig über den Halbleiterkörper und kann für den Strahlungsdurchtritt bereichsweise ausgespart sein.

Der Kontakt kann beispielsweise als Kontaktmetallisierung oder Kontaktlegierung ausgebildet sein.

In einer weiteren bevorzugten Ausgestaltung erstreckt sich ein Kontaktleiter, vorzugsweise schichtartig, von der vom Montagebereich abgewandten Seite des Halbleiterkörpers zum Anschlussträger hin. Über den Kontaktleiter kann die vom Montagebereich abgewandte Seite des jeweiligen Halbleiterkörpers mit einer externen elektrischen Anschlussfläche für das Bauelement elektrisch leitend verbunden werden. Der Kontaktleiter kann mit dem Anschlussbereich oder einem weiteren Anschlussbereich, der auf dem Anschlussträger ausgebildet ist, elektrisch leitend verbunden sein. Der Kontaktleiter erstreckt sich bevorzugt, insbesondere im Gegensatz zur Stromverteilungsstruktur, über die von dem Anschlussträger abgewandte Seite der Planarisierungsschicht.

Der Kontakt kann die Stromverteilungsstruktur und/oder den Kontaktleiter umfassen. Der Kontaktleiter und die Stromverteilungsstruktur können mittels Lithographie unter Verwendung einer gemeinsamen Maske auf den Anschlussträgerverbund aufgebracht werden. Die Stromverteilungsstruktur und der Kontaktleiter können eine durchgehende Schicht aufweisen. Der Kontakt, der Kontaktleiter und/oder die Stromverteilungsstruktur kann nach dem Aufbringen galvanisch verstärkt werden. Die Stromtragfähigkeit von galvanisch verstärkten Kontaktelementen ist vorteilhaft erhöht.

Der Kontaktleiter kann sich von der von dem Anschlussträger abgewandten Seite der Planarisierungsschicht, insbesondere entlang der Planarisierungsschicht, bis zu dem Anschlussbereich erstrecken und insbesondere mit dem Anschlussbereich elektrisch leitend verbunden sein.

Um eine Führung des Kontaktleiters entlang der Planarisierungsschicht in Richtung der dem Halbleiterkörper zugewandten Seite des Anschlussträgers zu erleichtern, kann die Planarisierungsschicht geeignet ausgebildet sein. Beispielsweise kann die Planarisierungsschicht auf einer vom Halbleiterkörper abgewandten Seite schräg zum Anschlussträger verlaufen. Der Kontaktleiter kann sich entlang der Schräge erstrecken. Vorzugsweise verbreitert sich daher die Planarisierungsschicht von ihrer vom Anschlussträger abgewandten Seite in Richtung des Anschlussträgers.

Der Kontaktleiter kann sich weiterhin durch eine Aussparung der Planarisierungsschicht, welche diese vorzugsweise aufweist, zum Anschlussträger hin erstrecken.

Das Planarisierungsmaterial kann hierzu entsprechend strukturiert auf den Anschlussträgerverbund aufgebracht werden oder das Planarisierungsmaterial kann, vorzugsweise nach dem Verfestigen für die Planarisierungsschicht, entsprechend strukturiert werden, so dass die Planarisierungsschicht ausgespart oder randseitig angeschrägt ist.

In einer weiteren bevorzugten Ausgestaltung ist neben dem Halbleiterkörper und insbesondere auf dem Anschlussträger eine Kontaktrampe angeordnet. Die Kontaktrampe kann vom Halbleiterkörper in Richtung der dem Halbleiterkörper zugewandten Seite des Anschlussträgers verlaufen und insbesondere in diese Richtung geneigt sein. Die Kontaktrampe kann der Führung des Kontaktleiters, der entlang der Kontaktrampe geführt werden kann, dienen. Der Kontaktleiter kann elektrisch leitend mit der vom Montagebereich abgewandten Seite des Halbleiterkörpers verbunden sein. Beispielsweise kann der Kontaktleiter entlang der Kontaktrampe zu dem Anschlussbereich oder einem weiteren Anschlussbereich des Anschlussträgers geführt sein. Die Kontaktrampe kann keilförmig ausgebildet sein. Die Kontaktrampe kann sich von dem Anschlussträger ausgehend verjüngen. Die Kontaktrampe kann durch die Planarisierungsschicht gebildet sein. Weiter oben und im folgenden im Zusammenhang mit der Planarisierungsschicht beschriebene Merkmale können sich daher auch auf die Kontaktrampe beziehen und umgekehrt.

Die Kontaktrampe kann sich nur bereichsweise neben dem Halbleiterkörper erstrecken. Die Kontaktrampe kann sich, vorzugsweise nur, in einem Teilbereich neben einer Seitenfläche des Halbleiterkörpers erstrecken. Bevorzugt erstreckt sich die Kontaktrampe über einen Anschlussleiterbereich des Anschlussbereichs, mit dem der Kontaktleiter elektrisch leitend verbunden ist.

In einer weiteren bevorzugten Ausgestaltung weist das Bauelement zwei auf der gleichen Seite des Anschlussträgers angeordnete externe Anschlussflächen auf. Die Anschlussflächen sind vorzugsweise auf verschiedenen Seiten des aktiven Bereichs elektrisch leitend mit dem Halbleiterkörper verbunden. Vorzugsweise sind die Anschlussflächen auf der von dem Halbleiterkörper abgewandten Seite des Anschlussträgers angeordnet. Die Anschlussflächen sind zweckmäßigerweise für die externe elektrische Kontaktbildung zum optoelektronischen Bauelement vorgesehen. Beispielsweise können die Anschlussflächen mit Leitern eines Leiterträgers, wie beispielsweise einer Leiterplatte verlötet werden. Das Bauelement kann also insbesondere als oberflächenmontierbares Bauelement ausgebildet sein.

Alternativ oder ergänzend können zwei externe Anschlussflächen des Bauelements auf der dem Halbleiterkörper zugewandten Seite des Anschlussträgers angeordnet sein. Die Anschlussflächen sind vorzugsweise auf verschiedenen Seiten des aktiven Bereichs elektrisch leitend mit dem Halbleiterkörper verbunden. Die Anschlussflächen können dann zum Beispiel jeweils über einen Bonddraht oder eine elektrisch leitfähige externe Anschlussverbindungsschicht, zum Beispiel eine elektrisch leitfähige Folie, mit einem Leiter eines Leiterträgers elektrisch leitend verbunden werden.

Alternativ oder ergänzend können zwei externe Anschlussflächen auf verschiedenen Seiten des Anschlussträgers angeordnet sein. Die Anschlussflächen sind vorzugsweise auf verschiedenen Seiten des aktiven Bereichs elektrisch leitend mit dem Halbleiterkörper verbunden.

In einer weiteren bevorzugten Ausgestaltung weist der Halbleiterkörper eine Dicke von 10 µm oder weniger, besonders bevorzugt von 7 µm oder weniger, z. B. von 6 µm oder weniger, auf.

In einer weiteren bevorzugten Ausgestaltung beträgt eine Ausdehnung des Halbleiterkörpers in Aufsicht auf den Anschlussträger, zum Beispiel die Länge und/oder die Breite des Halbleiterkörpers, 100 µm oder weniger oder 50 µm oder weniger, bevorzugt 40 µm oder weniger, besonders bevorzugt 30 µm oder weniger, z. B. 20 µm oder weniger oder 10 µm oder weniger.

In einer weiteren bevorzugten Ausgestaltung beträgt eine Dicke des Anschlussträgers 50 µm oder weniger, bevorzugt 40 µm oder weniger, besonders bevorzugt 30 µm oder weniger.

In einer weiteren bevorzugten Ausgestaltung beträgt eine Höhe des Bauelements 80 µm oder weniger, bevorzugt 60 µm oder weniger, besonders bevorzugt 50 µm oder weniger, z. B. 40 µm oder weniger.

Mittels des Verfahrens, bei dem die Halbleiterkörper auf den Anschlussträgerverbund übertragen werden, können also sehr dünne Bauelemente hergestellt werden. Weiterhin können auch Bauelemente mit Halbleiterkörpern verwirklicht werden, welche mittels herkömmlicher Positionierungsverfahren, wie beispielsweise Pick and Place-Prozessen, nicht oder nur erschwert in ein Gehäuse eingesetzt werden können.

Die Anschlussträger bzw. die Bauelementbereiche können eine vorgegebene Größe, insbesondere einen vorgegebenen Abstand zwischen zwei Anschlussbereichen, aufweisen, wobei verschiedene Geometrien oder Ausdehnungen der Halbleiterkörper mittels der weiter oben beschriebenen Kontaktführung ausgeglichen werden können.

In einer weiteren bevorzugten Ausgestaltung weist das optoelektronische Bauelement eine Mehrzahl von Halbleiterkörpern auf, welche jeweils eine Halbleiterschichtenfolge mit einem aktiven Bereich umfassen. Die Halbleiterkörper sind vorzugsweise nebeneinander auf dem Anschlussträger angeordnet und befestigt.

Jedem der Halbleiterkörper ist zweckmäßigerweise ein elektrischer Anschlussbereich zugeordnet. Dieser ist bevorzugt auf dem Anschlussträger ausgebildet. Die Halbleiterkörper sind weiterhin bevorzugt mit dem jeweils zugeordneten Anschlussbereich elektrisch leitend verbunden. Dabei kann ein Abstand benachbarter Halbleiterkörper 40 µm oder weniger, bevorzugt 30 µm oder weniger, besonders bevorzugt 20 µm oder weniger, z. B. 10 µm oder weniger oder 5 µm oder weniger betragen.

In einer weiteren bevorzugten Ausgestaltung sind zwei Halbleiterkörper mit einem gemeinsamen Anschlussbereich elektrisch leitend verbunden.

In einer weiteren bevorzugten Ausgestaltung sind die Halbleiterkörper matrixartig angeordnet. Weiterhin sind die Halbleiterkörper zweckmäßigerweise unabhängig voneinander elektrisch ansteuerbar.

In einer weiteren bevorzugten Ausgestaltung sind die aktiven Bereiche zweier Halbleiterkörper zur Erzeugung von Strahlung in verschiedenfarbigen Spektralbereichen ausgebildet.

Das Ausbilden des Bauelements als Anzeigevorrichtung, zum Beispiel als Bildanzeigevorrichtung, wird so erleichtert.

In einer weiteren bevorzugten Ausgestaltung ist auf der von dem Anschlussträger abgewandten Seite des Halbleiterkörpers und/oder auf der vom Anschlussträger abgewandten Seite der Planarisierungsschicht, bevorzugt auf der vom Anschlussträger abgewandten Seite des Kontakts ein Verkapselungsmaterial, ein Lumineszenzkonversionselement und/oder ein optisches Element, zum Beispiel eine Linse, angeordnet. Mit besonderem Vorteil können die oben genannten Elemente bereits im Anschlussträgerverbund vorgesehen und insbesondere mit dem Anschlussträgerverbund verbunden werden.

Bevorzugt wird daher auf dem Anschlussträgerverbund, insbesondere nach dem Vorsehen des Kontaktes und/oder der Planarisierungsschicht, ein optischer Elementverbund angeordnet. Der optische Elementverbund weist vorzugsweise eine Mehrzahl von optischen Elementbereichen auf. Vor dem Aufteilen des Anschlussträgerverbunds in optoelektronische Bauelemente oder während des Aufteilens kann der optische Elementverbund gegebenenfalls in optische Elemente durchtrennt werden. Auch das Lumineszenzkonversionselement und/oder das Verkapselungsmaterial kann auf die mit dem Anschlussträgerverbund verbundenen und insbesondere die auf dem Anschlussträgerverbund befestigten Halbleiterkörper aufgebracht werden.
In einer weiteren bevorzugten Ausgestaltung wird der Halbleiterkörperträger nach dem Trennen der Halbleiterkörper vom Halbleiterkörperträger entfernt und es wird ein weiterer Halbleiterkörperträger bereitgestellt.
Daraufhin können Halbleiterkörper, die auf dem weiteren Halbleiterkörperträger angeordnet sind, entsprechend dem oben beschriebenen Verfahren mit dem Anschlussträgerverbund verbunden und vom weiteren Halbleiterkörperträger getrennt werden. Dabei können Halbleiterkörper, die auf dem weiteren Halbleiterkörperträger angeordnet sind, jeweils auf einem bereits mit dem Anschlussträgerverbund verbundenen Halbleiterkörper befestigt und insbesondere elektrisch leitend mit dem letzteren, also dem bereits mit dem Anschlussträgerverbund verbundenen, Halbleiterkörper verbunden werden.
Figur 1 zeigt ein Ausführungsbeispiel eines Verfahrens zur Herstellung einer Mehrzahl optoelektronischer Bauelemente anhand von in den Figuren 1A und 1B in schematischen Schnittansichten dargestellten Zwischenschritten.
Figur 2 zeigt anhand einer schematischen Schnittansicht ein Ausführungsbeispiel für ein optoelektronisches Bauelement.
Figur 3 zeigt ein weiteres Ausführungsbeispiel für ein Verfahren zur Herstellung einer Mehrzahl von optoelektronischen Bauelementen anhand von Zwischenschritten, welche in den Figuren 3A bis 3C in schematischen Schnittansichten dargestellt sind.
Figur 4 zeigt in den Figuren 4A bis 4D Anschlussträger für das Verfahren oder für ein Bauelement anhand verschiedener Ansichten.
Figur 5 zeigt eine Teilaufsicht auf eine Anschlussträgerschicht.
Figur 6 zeigt anhand einer schematischen Aufsicht in Figur 6A und einer schematischen Schnittansicht in Figur 6B entlang der Linie A-A aus Figur 6A ein Ausführungsbeispiel eines optoelektronischen Bauelements.
Figur 7 zeigt ein weiteres Ausführungsbeispiel eines optoelektronischen Bauelements anhand einer schematischen Schnittansicht.
Figur 8 zeigt ein weiteres Ausführungsbeispiel für ein optoelektronisches Bauelement anhand einer schematischen Aufsicht.
Figur 9 zeigt ein weiteres Ausführungsbeispiel eines optoelektronischen Bauelements anhand einer schematischen Aufsicht.
Figur 10 zeigt zwei Halbleiterkörper anhand schematischer Aufsichten in den Figuren 10A und 10B.
Figur 11 zeigt ein weiteres Ausführungsbeispiel eines optoelektronischen Bauelements anhand einer schematischen Schnittansicht.
Figur 12 zeigt ein weiteres Ausführungsbeispiel eines optoelektronischen Bauelements anhand einer schematischen Aufsicht.
Figur 13 zeigt ein weiteres Ausführungsbeispiel eines optoelektronischen Bauelements anhand einer schematischen Schnittansicht.
Figur 14 zeigt ein weiteres Ausführungsbeispiel eines optoelektronischen Bauelements anhand zweier schematischer Aufsichten in den Figuren 14A und 14B. Figur 14A zeigt eine Aufsicht auf die Seite des Anschlussträgers, auf der der Halbleiterkörper des Bauelements angeordnet ist. Figur 14B zeigt eine Aufsicht auf die von dem Halbleiterkörper abgewandte Seite des Anschlussträgers.
Figur 15 zeigt ein weiteres Ausführungsbeispiel eines optoelektronischen Bauelements anhand einer schematischen Aufsicht.

Gleiche, gleichartige und gleich wirkende Elemente sind in den Figuren mit gleichen Bezugszeichen versehen.

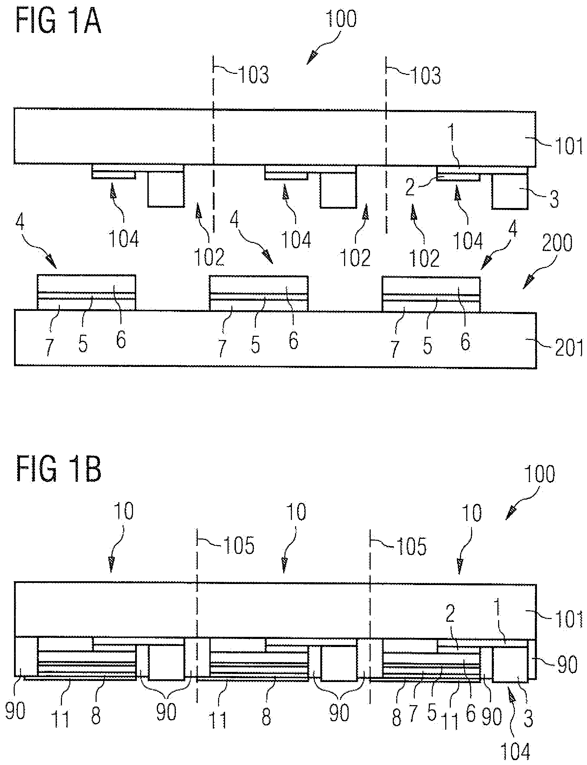

Figur 1 zeigt ein Ausführungsbeispiel eines Verfahrens zur Herstellung einer Mehrzahl optoelektronischer Bauelemente anhand von in den Figuren 1A und 1B in schematischen Schnittansichten dargestellten Zwischenschritten.

Zunächst wird ein Anschlussträgerverbund 100 bereitgestellt, Figur 1A. Der Anschlussträgerverbund umfasst dabei eine Anschlussträgerschicht 101. Der Anschlussträgerverbund 100 weist eine Mehrzahl von Bauelementbereichen 102 auf. Die Bauelementbereiche sind durch Bereiche der Anschlussträgerschicht 101 gebildet und in Figur 1A als durch die gestrichelten Linien 103 voneinander getrennt dargestellt. Die Anschlussträgerschicht 101 ist zweckmäßigerweise elektrisch isolierend ausgebildet.

In dem jeweiligen Bauelementbereich ist ein elektrischer Anschlussbereich 104 ausgebildet. Der elektrische Anschlussbereich 104 enthält bevorzugt ein Metall oder eine Mehrzahl von Metallen oder eine Metallverbindung oder besteht hieraus. Der Anschlussbereich 104 kann eine Anschlussleiterschicht 1 aufweisen. Die Anschlussleiterschicht 1 kann auf die Anschlussträgerschicht 101 aufgebracht, zum Beispiel abgeschieden sein. Hierzu eignet sich beispielsweise Aufdampfen oder Sputtern. Die Anschlussleiterschicht 1 enthält bevorzugt ein Metall, zum Beispiel Au, oder besteht hieraus. Nach dem Aufbringen der Anschlussleiterschicht 1 kann die Anschlussleiterschicht 1 galvanisch verstärkt werden. Die Stromtragfähigkeit der Anschlussleiterschicht wird so erhöht.

Die Anschlussleiterschicht kann beispielsweise mittels einer Maske, wie etwa einer Photomaske, strukturiert abgeschieden sein.

Auf der von der Anschlussträgerschicht 101 abgewandten Seite der Anschlussleiterschicht 1 ist eine Befestigungsschicht 2 des jeweiligen Anschlussbereichs 104 angeordnet. Die Befestigungsschicht 2 ist zweckmäßigerweise elektrisch leitfähig ausgeführt. Gleiches gilt für die Anschlussleiterschicht 1. Die Befestigungsschicht 2 kann als Lotschicht, zum Beispiel als Gold-Zinn-Lotschicht, oder als elektrisch leitfähig ausgebildete Klebeschicht, zum Beispiel als Silberleitkleberschicht, ausgeführt sein.

Die Befestigungsschicht 2 kann mittels einer geeigneten Maske auf die Anschlussträgerschicht aufgebracht sein (nicht explizit dargestellt). Weiterhin umfasst der Anschlussbereich 104 ein elektrisches Anschlussteil 3. Das Anschlussteil 3 kann die Befestigungsschicht 2 überragen. Das Anschlussteil 3 kann als Anschlussplättchen, zum Beispiel als Metallplättchen, ausgeführt sein. Das Anschlussteil 3 kann auf die Anschlussträgerschicht 101 und insbesondere die Anschlussleiterschicht 1 aufgebracht sein.

Eine Dicke der Anschlussleiterschicht 1 beträgt bevorzugt 5 µm oder weniger, besonders bevorzugt 3 µm oder weniger, z. B. 1 µm oder weniger. Eine Dicke der Befestigungsschicht 2 beträgt bevorzugt 5 µm oder weniger, besonders bevorzugt 3 µm oder weniger, z. B. 2 µm oder weniger. Das Anschlussteil 3 kann eine Dicke von 10 µm oder weniger, bevorzugt 8 µm oder weniger aufweisen.

Die Anschlussträgerschicht 101 kann als Folie ausgeführt sein. Die Anschlussträgerschicht kann insbesondere eine Dicke von 80 µm oder weniger, bevorzugt von 50 µm oder weniger, besonders bevorzugt von 40 µm oder weniger, z. B. 30 µm oder weniger oder 20 µm oder weniger aufweisen.

Der mit der Befestigungsschicht 2 belegte Bereich des Anschlussbereichs 104 bildet einen Montagebereich des jeweiligen Bauelementbereichs. In dem Montagebereich können Halbleiterkörper auf dem Anschlussträgerverbund befestigt werden.

Die Anschlussträgerschicht 101 ist bevorzugt strahlungsdurchlässig für eine in einem Halbleiterkörper, welcher auf der Anschlussträgerschicht 101 nachfolgend befestigt wird, erzeugt werden kann. Beispielsweise kann die Anschlussträgerschicht ein Glas, etwa eine Glasfolie, aufweisen.

Die Bauelementbereiche 102 sind vorzugsweise flächig über den Anschlussträgerverbund und insbesondere die Anschlussträgerschicht verteilt.

Weiterhin wird in dem Verfahren ein Halbleiterkörperverbund 200 bereitgestellt. Der Halbleiterkörperverbund weist einen Halbleiterkörperträger 201 auf. Auf dem Halbleiterkörperträger 201 ist eine Mehrzahl von Halbleiterkörpern 4 angeordnet und insbesondere befestigt. Die Halbleiterkörper 4 sind vorzugsweise flächig über den Halbleiterkörperträger 201 verteilt angeordnet.

Die Halbleiterkörper 4 umfassen jeweils einen aktiven Bereich 5. Der aktive Bereich 5 ist vorzugsweise zur Strahlungserzeugung ausgebildet. Bevorzugt ist der jeweilige Halbleiterkörper als Lumineszenzdioden-Halbleiterkörper ausgeführt.

Weiterhin umfassen die Halbleiterkörper 4 jeweils eine Halbleiterschichtenfolge. Beispielsweise kann der aktive Bereich 5 zwischen zwei Halbleiterschichten 6, 7 angeordnet sein. Diese Halbleiterschichten 6, 7 sind vorzugsweise von unterschiedlichen Leitungstypen, insbesondere für unterschiedliche Leitungstypen dotiert (n-leitend oder p-leitend). Die Halbleiterschicht 6 kann n-leitend oder p-leitend ausgebildet sein.

Die Halbleiterkörper 4 sind weiterhin bevorzugt epitaktisch gewachsen. Eine Halbleiterschichtstruktur für die Halbleiterkörper kann auf einem Aufwachssubstrat epitaktisch, zum Beispiel MOVPE (metallorganische Gasphasenepitaxie), abgeschieden sein. Aus der Halbleiterschichtstruktur können dann Halbleiterkörper, zum Beispiel mittels Ätzen ausgebildet werden.

Der Halbleiterkörperverbund und der Anschlussträgerverbund sind derart relativ zueinander angeordnet, dass die Halbleiterkörper 4 den Bauelementbereichen 102 zugewandt sind.

Die Halbleiterkörper 4 sind weiterhin bevorzugt gemäß einem regulären Muster auf dem Halbleiterkörper 201 angeordnet. Zweckmäßigerweise sind der Anschlussträgerverbund 100 und der Halbleiterkörperverbund 200 derart aufeinander abgestimmt, dass sich der jeweilige Halbleiterkörper über den Montagebereich - also die Befestigungsschicht 2 im jeweiligen Bauelementbereich 102 - des diesem Halbleiterkörper zugeordneten Bauelementbereichs erstreckt.

Hierzu kann entweder eine Anordnung der Halbleiterkörper auf dem Halbleiterkörperträger entsprechend den vorgegebenen Montagebereichen eines Anschlussträgerverbundes ausgebildet werden, oder die Montagebereiche eines Anschlussträgerverbundes können gemäß einer vorgegebenen Anordnung von Halbleiterkörpern auf einem Halbleiterkörperträger ausgebildet werden.

Für eine Anordnung der Halbleiterkörper auf dem Halbleiterkörperträger gemäß den Bauelementbereichen können Halbleiterkörper, welche auf dem Aufwachssubstrat angeordnet sind, auf einem Zwischenträger befestigt werden (nicht dargestellt). Das Aufwachssubstrat kann daraufhin von den Halbleiterkörpern entfernt werden. Hierzu eignet sich beispielsweise ein Lasertrennverfahren oder Ätzen. Von den auf dem Zwischenträger angeordneten Halbleiterkörpern können Halbleiterkörper derart ausgewählt werden und mit dem Halbleiterkörperträger verbunden werden, dass die Anordnung der auf dem Halbleiterkörperträger 201 angeordneten Halbleiterkörper derjenigen der Montagebereiche entspricht. Hierzu werden zweckmäßigerweise Halbleiterkörper selektiv von dem Zwischenträger entfernt und gemäß der Anordnung der Montagebereiche auf den Halbleiterkörperträger übertragen. Alternativ können selektierte Halbleiterkörper vom Aufwachssubstrat, zum Beispiel mittels eines Lasertrennverfahrens, abgetrennt und mit dem Halbleiterkörperträger 201 verbunden werden. Auf einen Zwischenträger kann dann verzichtet werden.

Für den Halbleiterkörperträger 201 eignet sich beispielsweise eine Schicht, zum Beispiel eine Folie, wie etwa eine Thermorelease-Folie. Die Folie kann auf einem zusätzlichen Hilfsträger (nicht dargestellt) angeordnet sein, um dem Halbleiterkörperverbund 200 eine erhöhte mechanische Stabilität zu verleihen.

Daraufhin werden der Anschlussträgerverbund 100 und der Halbleiterkörperträger 201 derart zueinander angeordnet, dass die Halbleiterkörper 4 mit dem Anschlussträgerverbund, insbesondere den Befestigungsschichten 2 des dem jeweiligen Halbleiterkörper 4 zugeordneten Bauelementbereichs in mechanischen Kontakt treten. Nachfolgend können die Halbleiterkörper 4 auf der Anschlussträgerschicht 101 befestigt werden.

Dies kann zum Beispiel durch Verlöten oder Verkleben der Halbleiterkörper mit dem Anschlussträgerverbund mittels der Befestigungsschicht 2 erfolgen.

Nach dem Befestigen der Halbleiterkörper 4 am Anschlussträgerverbund 100 können die Halbleiterkörper von dem Halbleiterkörperträger 201 getrennt werden. Hierzu kann der Halbleiterkörperträger 201 von den Halbleiterkörpern abgelöst werden. Dazu eignet sich zum Beispiel ein Lasertrennverfahren oder Ätzen. Wird eine Thermorelease-Folie für den Halbleiterkörperträger eingesetzt, so können die Halbleiterkörper durch Erwärmen der Thermorelease-Folie vom Halbleiterkörperträger getrennt werden. Die haftvermittelnde Wirkung einer Thermorelease-Folie wird durch Erwärmen vermindert. Nach dem Trennen der Halbleiterkörper kann der Halbleiterkörperträger entfernt werden, Figur 1B.

Der Anschlussbereich 104 ist dabei bereichsweise, bevorzugt nur bereichsweise, zwischen der Anschlussträgerschicht 101 und dem Halbleiterkörper 4 angeordnet. Die der Anschlussträgerschicht 101 zugewandte Seite des jeweiligen Halbleiterkörpers wird daher mit Vorteil nicht vollständig von dem Anschlussbereich 104 abgeschattet. Eine Absorption von Strahlung im Anschlussbereich 104 kann so gering gehalten werden.

Bevorzugt ist die Befestigungsschicht 2 vollflächig, die Anschlussleiterschicht 1 nur bereichsweise zwischen dem Halbleiterkörper und der Anschlussträgerschicht angeordnet. Das Anschlussteil 3 kann sich neben dem Halbleiterkörper bis zu der von der Anschlussträgerschicht 101 abgewandten Seite des Halbleiterkörpers erstrecken.

Nach dem Trennen der Halbleiterkörper 4 von dem Halbleiterkörperträger 201 kann auf die von der Anschlussträgerschicht abgewandte Seite der Halbleiterkörper 4 eine Spiegelschicht 8 aufgebracht werden. Die Spiegelschicht 8 kann alternativ bereits auf den noch auf dem Halbleiterkörperträger 201 angeordneten Halbleiterkörpern angeordnet sein. Zweckmäßigerweise ist die Spiegelschicht dann zwischen dem jeweiligen Halbleiterkörper 4 und dem Halbleiterkörperträger 201 angeordnet.

Die Spiegelschicht 8 ist bevorzugt elektrisch leitfähig ausgeführt und insbesondere elektrisch leitend mit dem aktiven Bereich verbunden. Besonders bevorzugt enthält die Spiegelschicht ein Metall oder eine Metallverbindung. Beispielsweise enthält die Spiegelschicht Au, Al oder Ag oder besteht hieraus. Derartige Materialien zeichnen sich durch hohe Reflektivitäten für im aktiven Bereich erzeugbare Strahlung aus.

Die Spiegelschicht 8 kann eine Dicke von 1 µm oder weniger, bevorzugt von 800 nm oder weniger, besonders bevorzugt von 500 nm oder weniger, z. B. von 300 nm oder weniger, aufweisen.

Auf den Anschlussträgerverbund 100 wird nachfolgend eine Formmasse 90 aufgebracht. Die Formmasse ist vorzugsweise elektrisch isolierend. Ferner ist die Formmasse für im aktiven Bereich zu erzeugende Strahlung bevorzugt durchlässig. Ein Kurzschluss des gegebenenfalls freiliegenden aktiven Bereichs 5 über die Formmasse wird so vermieden. Die Formmasse kann beispielsweise BCB enthalten. Vorzugsweise wird die Formmasse auf den Anschlussträgerverbund 100 aufgeschleudert. Daraufhin wird die Formmasse verfestigt, zum Beispiel mittels thermischen Härtens.

Soweit die von der Anschlussträgerschicht 101 abgewandte Seite der Halbleiterkörper mit der Formmasse bedeckt ist wird der auf dieser Seite der Halbleiterkörpers angeordnete Teil der Formmasse entfernt. Die von der Anschlussträgerschicht 101 abgewandte Seite des Halbleiterkörpers 4 wird hierdurch wieder freigelegt. Die gegebenenfalls gehärtete Formmasse kann hierzu abgeschliffen werden. Auch ein Fly-Cutting Verfahren ist für das Entfernen der gegebenenfalls gehärteten Formmasse geeignet.

Die Formmasse schützt mit Vorteil den jeweiligen Halbleiterkörper.

Auf die von der Anschlussträgerschicht 101 abgewandte Seite der Halbleiterkörper wird nachfolgend ein elektrischer Kontakt 11, z. B. eine Kontaktmetallisierung, aufgebracht. Der Kontakt kann z. B. Ti, Pt und/oder Au enthalten.

Der Kontakt 11 kann eine Dicke von 5 µm oder weniger, bevorzugt 3 µm oder weniger, besonders bevorzugt 2 µm oder weniger, z. B. 1 µm oder weniger, 800 nm oder weniger, 500 nm oder weniger oder 300 nm oder weniger, aufweisen.

Für das Aufbringen der Spiegelschicht 8 und/oder das Aufbringen des Kontaktes 11 eignet sich beispielsweise ein Abscheideverfahren, wie Sputtern oder Aufdampfen. Der Kontakt 11 erstreckt sich vorzugsweise schichtartig und insbesondere großflächig über den Halbleiterkörper 4. Der Kontakt 11 ist mit dem Halbleiterkörper 4, insbesondere über die Spiegelschicht 8 elektrisch leitend verbunden. Über das Anschlussteil 3 und den Kontakt 11 kann der Halbleiterkörper 4 elektrisch kontaktiert werden.

Der Kontakt 11 kann sich dabei über die von der Anschlussträgerschicht 101 abgewandte Seite der verfestigten Formmasse 90 erstrecken. Mittels der Formmasse ist vorzugsweise eine Planarisierungsschicht gebildet.

Nachfolgend kann der Anschlussträgerverbund 100 entlang der Linien 105 in optoelektronische Bauelemente 10, die jeweils zumindest einen, vorzugsweise genau einen, Bauelementbereich 102 umfassen, vereinzelt werden. Das Vereinzeln kann beispielsweise durch Sägen oder ein Laser-gestütztes Vereinzelungsverfahren erfolgen. Beim Vereinzeln kann die Anschlussträgerschicht 101 durchtrennt werden. Weiterhin kann die Formmasse 90 durchtrennt werden.

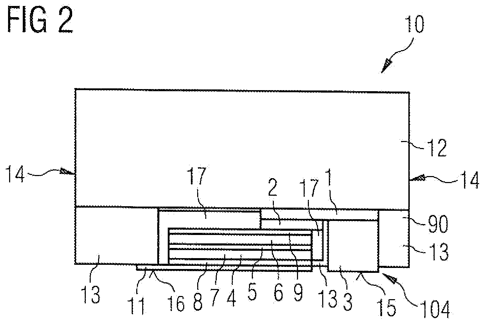

Figur 2 zeigt anhand einer schematischen Schnittansicht ein gemäß dem Verfahren nach Figur 1 hergestelltes optoelektronisches Bauelement 10.

Das optoelektronische Bauelement 10 weist einen Anschlussträger 12 auf. Dieser ist vorzugsweise aus der Anschlussträgerschicht 101 vereinzelt. Weiterhin weist das Bauelement eine Planarisierungsschicht 13 auf. Diese ist neben dem Halbleiterkörper angeordnet und kann aus der Formmasse 90 gebildet sein. Über das Anschlussteil 3 und den Kontakt 11 kann das Bauelement mit einem externen Leiterelement, zum Beispiel der Leiterbahn oder Leiterplatte elektrisch leitend verbunden, zum Beispiel verlötet, werden.

Das Bauelement ist insbesondere oberflächenmontierbar ausgeführt. Der Anschlussbereich 104, insbesondere die Anschlussschicht 1, ist bereichsweise zwischen dem Halbleiterkörper 4 und dem Anschlussträger 12 angeordnet und erstreckt sich neben den Halbleiterkörper. Externe elektrische Anschlussflächen 15, 16 sind auf der vom Anschlussträger 12 abgewandten Seite des Bauelements ausgebildet.

Der Anschlussträger 12 gemäß Figur 2 weist einen elektrisch isolierenden Trägerkörper 18, z. B. aus Glas, auf, auf dem der Anschlussbereich 104 ausgebildet, insbesondere abgeschieden ist. Der Anschlussträger wird im Betrieb des Bauelements zweckmäßigerweise von der im Halbleiterkörper erzeugten Strahlung durchstrahlt.

Das Bauelement weist mit Vorzug eine durchgehend vereinzelte Seitenfläche 14 auf. Diese kann durch den Anschlussträger und gegebenenfalls die Planarisierungsschicht 13 gebildet sein.

Mittels der Spiegelschicht 8 kann im Halbleiterkörper 4 erzeugte die Strahlung in Richtung des Anschlussträgers 12 reflektiert werden. Die aus dem Anschlussträger ausgekoppelte Strahlungsleistung wird so erhöht.

Im Unterschied zu dem Verfahren gemäß Figur 1 weist das Bauelement 10 gemäß Figur 2 eine Passivierungsschicht 17 auf. Diese ist vorzugsweise auf den Halbleiterkörper 4 aufgebracht. Eine Passivierungsschicht kann auf die Halbleiterkörper im Halbleiterkörperverbund, insbesondere vollflächig über den gesamten Verbund, aufgebracht werden. Für die elektrische Kontaktbildung zum Halbleiterkörper mittels des Anschlussbereichs 104 kann die Passivierungsschicht vor der Befestigung der Halbleiterkörper am Anschlussträgerverbund bereichsweise entfernt werden. Die Passivierungsschicht 17 ist vorzugsweise elektrisch isolierend ausgebildet. Beispielsweise enthält die Passivierungsschicht ein Siliziumnitrid, ein Siliziumoxid oder ein Siliziumoxinitrid. Die Passivierungsschicht erstreckt sich bevorzugt neben dem Halbleiterkörper und entlang des Halbleiterkörpers. Die Passivierungsschicht 17 kann sich zwischen dem Halbleiterkörper 4 und dem Anschlussträger 12 erstrecken. Die Passivierungsschicht 17 kann den Halbleiterkörper 4 weitergehend schützen. Weiterhin kann der Übertritt von Strahlung vom Halbleiterkörper in den Anschlussträger 12 mittels der Passivierungsschicht erleichtert werden. Die Passivierungsschicht kann insbesondere als Brechungsindexanpassungsschicht zwischen Halbleiterkörper und dessen Umgebung, also der von dem Halbleiterkörper abgewandten Seite der Passivierungsschicht, dienen. Fortgesetzte Totalreflexion im Halbleiterkörper kann so gemindert werden.

Im Unterschied zu dem im Verfahren gemäß Figur 1 hergestellten Bauelement weist das Bauelement gemäß Figur 2 eine elektrische Kontaktschicht 9, z. B. eine Kontaktmetallisierung, auf. Die Kontaktschicht 9 ist mit dem Halbleiterkörper 4 elektrisch leitend verbunden. Weiterhin ist die Kontaktschicht 9 bevorzugt zwischen dem Anschlussträger 12 und dem Halbleiterkörper 4 angeordnet. Die Kontaktschicht 9 kann auf die noch auf dem Halbleiterkörperträger 200 angeordneten Halbleiterkörper aufgebracht werden. Die Kontaktschicht kann mittels eines lithographischen, insbesondere photolithographischen, Verfahrens abgeschieden werden.

Die Kontaktschicht 9 ist zweckmäßigerweise zwischen dem Halbleiterkörper und der Befestigungsschicht 2 angeordnet. Die Kontaktschicht 9 kann sich großflächig über den Halbleiterkörper erstrecken.

Die Kontaktschicht ist zweckmäßigerweise strahlungsdurchlässig ausgebildet. Für den Strahlungsdurchtritt kann die Kontaktschicht 9 bereichsweise ausgespart sein. Die Kontaktschicht kann insbesondere eine Stromverteilungsstruktur 26 aufweisen, die weiter unten im Zusammenhang mit anderen Ausführungsbeispielen näher beschrieben ist.

Die Kontaktschicht 9 kann ein strahlungsdurchlässiges und elektrisch leitfähiges Oxid, insbesondere ein Metalloxid, enthalten. Ein strahlungsdurchlässiges und elektrisch leitfähiges Oxid (TCO: Transparent Conductive Oxide), wie z. B. ein Zinnoxid, ein Zinkoxid oder ein Indiumzinnoxid, kann von der im aktiven Bereich erzeugten Strahlung durchstrahlt werden. Auf eine Aussparung der Kontaktschicht 9 für den Strahlungsdurchtritt, was insbesondere bei einer Metallisierung für die Kontaktschicht zweckmäßig ist, kann dann verzichtet werden. Die Kontaktschicht kann insbesondere vereinfacht, also ohne ein erhöhtes Risiko von Absorptionsverlusten, als durchgehende, also aussparungsfreie, Schicht ausgeführt werden.

Die Befestigungsschicht 2 ist mit der Kontaktschicht zweckmäßigerweise elektrisch leitend verbunden. Die Befestigungsschicht überdeckt den Halbleiterkörper bevorzugt nur teilweise. Über die Kontaktschicht 9 können Ladungsträger lateral über den Halbleiterkörper verteilt und homogen in den aktiven Bereich 5 zur Strahlungserzeugung gelangen. Ladungsträger können über die Anschlussleiterschicht 1 lateral in den Bereich zwischen dem Halbleiterkörper und den Anschlussträger eingeleitet werden. Über die Befestigungsschicht werden die Ladungsträger der Kontaktschicht 9 zugeleitet und können von dort aus in den Halbleiterkörper 4 injiziert werden.

Die Kontaktschicht kann dabei eine Schichtenfolge umfassen, beispielsweise vom Halbleiterkörper aus gesehen eine Ti-Schicht, eine Pt Schicht und eine Au-Schicht (nicht explizit dargestellt). Vorzugsweise wird die Kontaktschicht(enfolge) auf der vom Halbleiterkörper angewandten Seite von einer Verlötungsschicht abgeschlossen. Eine die Kontaktschichtenfolge abschließende Au-Schicht ist zur Verlötung mit einer Lotschicht, z. B. einer AuSn-Schicht, als Befestigungsschicht besonders geeignet.

Die Kontaktschicht 9 kann eine Dicke von 5 µm oder weniger, bevorzugt 3 µm oder weniger, besonders bevorzugt 2 µm oder weniger, z. B. 1 µm oder weniger, 800 nm oder weniger, 500 nm oder weniger oder 300 nm oder weniger, aufweisen.

Eine Gesamthöhe des Bauelements kann 40 µm oder weniger, z. B. 38 µm, betragen. Der Halbleiterkörper 4 kann eine Dicke von 10 µm oder weniger, bevorzugt von 7 µm oder weniger, aufweisen. Eine Dicke des Anschlussträgers 12 kann 50 µm oder weniger, bevorzugt 40 µm oder weniger, besonders bevorzugt 30 µm oder weniger, betragen.

Der auf dem Anschlussträger angeordnete Teil des Bauelements 10 kann eine Gesamtdicke von 10 µm oder weniger aufweisen. Beispielsweise kann der Anschlussträger 12 eine Dicke von 30 µm und der verbleibende Teil des Bauelements eine Gesamtdicke von 8 µm aufweisen. Der Halbleiterkörper 2 kann eine Dicke von 6 µm aufweisen.

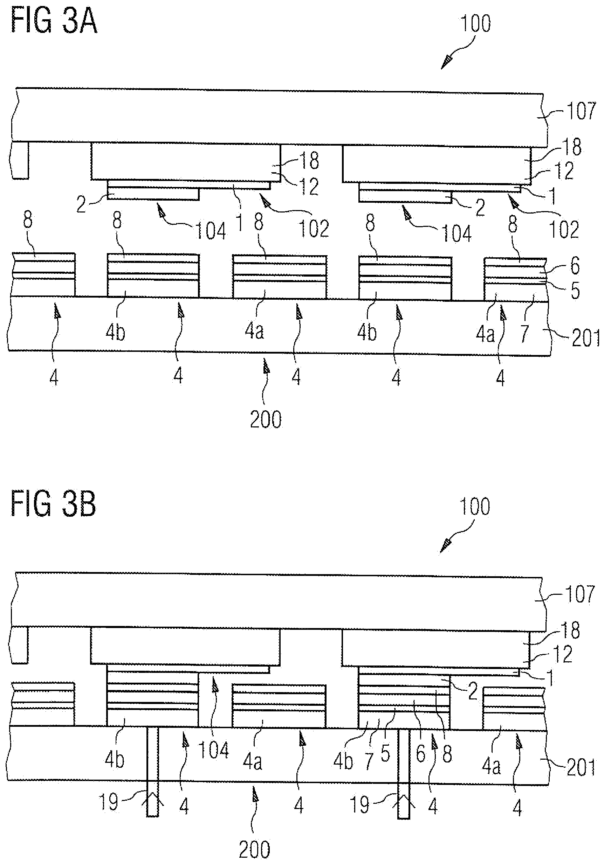

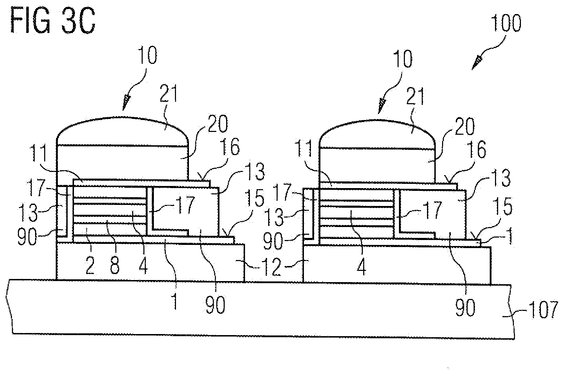

Figur 3 zeigt ein weiteres Ausführungsbeispiel für ein Verfahren zur Herstellung einer Mehrzahl von optoelektronischen Bauelementen anhand von Zwischenschritten, welche in den Figuren 3A bis 3C in schematischen Schnittansichten dargestellt sind.

Im Wesentlichen entspricht das Verfahren dem im Zusammenhang mit Figur 1 beschriebenen Verfahren.

Zunächst wird der Anschlussträgerverbund 100 bereitgestellt, Figur 3A. Im Gegensatz zu dem Ausführungsbeispiel gemäß Figur 1 weist der Verbund 100 keine durchgehende Anschlussträgerschicht auf, auf der Bauelementbereiche 102 ausgebildet sind, die jeweils einen Anschlussbereich 104 aufweisen. Vielmehr weist der Anschlussträgerverbund gemäß Figur 3A eine Mehrzahl gesonderter, auf einem Hilfsträger 107, insbesondere einer Hilfsträgerschicht, angeordneter Anschlussträger 12 auf. Die Anschlussträger 12 sind zweckmäßigerweise auf dem Hilfsträger befestigt. Ein Anschlussträger 12 kann insbesondere einem Bauelementbereich 102 entsprechen.

Der jeweilige Anschlussträger 12 weist einen elektrisch isolierenden Trägerkörper 18 auf, auf dem der Anschlussbereich 104 ausgebildet, insbesondere abgeschieden ist.

Der Trägerkörper 18 des jeweiligen Anschlussträgers 12 ist bevorzugt als Wärmesenke ausgebildet. Der Trägerkörper 18 enthält hierzu zweckmäßigerweise ein Material hoher Wärmeleitfähigkeit, z. B. von 70 W/(m*K) oder mehr, bevorzugt von 100 W/(m*K) oder mehr, besonders bevorzugt von 200 W/(m*K) oder mehr. Der Trägerkörper 18 kann insbesondere eine Keramik, z. B. eine Aluminiumnitrid- oder Aluminiumoxid-Keramik Auch ein elektrisch isolierender Trägerkörper, der zum Beispiel Silizium enthält, kann eingesetzt werden.

Für den Hilfsträger 107 eignet sich z. B. ein Saphir- oder Silizium-haltiger Hilfsträger. Die Anschlussträger können auf den Hilfsträger geklebt sein.

Der Anschlussträgerverbund 100 ist weiterhin bevorzugt als Anschlussträgerwafer mit flächig über den Verbund verteilten Bauelementbereichen 102 bzw. Anschlussträgern ausgebildet.

Weiterhin wird der Halbleiterkörperverbund 200 mit dem Halbleiterkörperträger 201 und der Mehrzahl von auf dem Halbleiterkörperträger angeordneten Halbleiterkörpern 4 bereitgestellt. Im Unterschied zu dem Verfahren gemäß Figur 1 ist die Anordnung der Halbleiterkörper 4 auf dem Halbleiterkörperträger 201 nicht auf die der Montagebereiche - also auf die Anordnung der Befestigungsschichten 2 - abgestimmt. Insbesondere weist der Halbleiterkörperverbund 200 Halbleiterkörper 4 auf, die sich nicht über einen Montagebereich erstrecken (vgl. z. B. die Halbleiterkörper 4a).

Der Halbleiterkörperträger 201 ist bevorzugt aus dem Aufwachssubstrat gebildet, auf dem eine Halbleiterschichtstruktur epitaktisch gewachsen wurde, aus der die Halbleiterkörper ausgebildet sind. Die Halbleiterkörper können lithographisch, insbesondere mittels einer photolithographisch ausgebildeten Maske und nachfolgendem Ätzen, aus der Halbleiterschichtstruktur ausgebildet sein.

Ein Abstand benachbarter Halbleiterkörper auf dem Halbleiterkörperträger kann 40 µm oder weniger, bevorzugt 30 µm oder weniger, besonders bevorzugt 20 µm oder weniger, z. B. 10 µm oder weniger oder 5 µm oder weniger, betragen. Der Abstand zwischen benachbarten Halbleiterkörpern kann beispielsweise 2 µm betragen. Da die Halbleiterkörper ohne Zerteilen, z. B. Zersägen, des Halbleiterkörperträgers auf den Anschlussträgerverbund 100 übertragen werden können (siehe oben zu Figur 1 und weiter unten), müssen Zwischenräume zwischen den Halbleiterkörpern nicht an den Zerteilungsprozess angepasst werden. Sägen erfordert relativ breite Gräben zwischen den Halbleiterkörpern von oftmals 60 µm oder mehr. Im Rahmen des vorgeschlagenen Verfahrens können die Halbleiterkörper auf dem Halbleiterkörperträger dicht gepackt sein. Durch eine Verringerung des Abstands zwischen den Halbleiterkörpern wird die Ausbeute an Halbleitermaterial aus der Halbleiterschichtstruktur erhöht. Dies erhöht die Effizienz des Herstellungsverfahrens und verringert die Kosten.

Für die Ausbildung geringer Abstände zwischen den Halbleiterkörpern eignet sich z. B. ein Plasmaätz-Verfahren, z. B. Hochraten-Plasmaätzen.

Auf den Halbleiterkörpern 4 ist eine Spiegelschicht 8 angeordnet. Die Spiegelschicht 8 ist weiterhin auf der von dem Halbleiterkörperträger 201 abgewandten Seite des jeweiligen Halbleiterkörpers 4 angeordnet. Auf der von dem Halbleiterkörper abgewandten Seite der Spiegelschicht können weitere, insbesondere metallische, Schichten angeordnet sein (nicht explizit dargestellt). Es kann z. B. eine Barriereschicht, die die Spiegelschicht schützt, vorgesehen sein. Die Gefahr einer Reflektivitätsminderung der Spiegelschicht beim Befestigen auf dem Anschlussträgerverbund kann so verringert werden. Beispielsweise können in der Abfolge vom Halbleiterkörper aus gesehen eine TiW(N)-Schicht als Barriereschicht, gefolgt von einer haftvermittelnden Schicht, z. B. einer Ti-Schicht, einer Pt-Schicht und einer Au-Schicht vorgesehen sein.

Der Halbleiterkörperträger 201 und der Anschlussträgerverbund 101 sind derart zueinander angeordnet, dass die Halbleiterkörper 4 den Bauelementbereichen 102 zugewandt sind.

Daraufhin werden Halbleiterkörper 4 auf dem Montagebereich, über den sie sich erstrecken, abgelegt, Figur 3B. Aufgrund der nur bereichsweise auf der Anschlussleiterschicht 1 vorgesehenen Befestigungsschicht 2 erhebt sich der Montagebereich über die Anschlussleiterschicht. Dadurch kann vermieden werden, dass Halbleiterkörper 4a, welche sich nicht über die Befestigungsschicht erstrecken, mit dem Anschlussträgerverbund in mechanischen Kontakt treten. Die Gefahr, dass nicht auf den Anschlussträgerverbund zu übertragende Halbleiterkörper, z. B. durch Anhaften an der Anschlussleiterschicht 1, auf den Anschlussträgerverbund gelangen, wird so verringert.

Nachfolgend werden die auf dem Anschlussträgerverbund zu montierenden Halbleiterkörper 4b über die Befestigungsschicht 2 auf dem Anschlussträgerverbund befestigt, z. B. geklebt oder gelötet.

Daraufhin werden die Halbleiterkörper 4b, welche mit dem Anschlussträgerverbund 100 verbunden sind von dem Halbleiterkörperträger 201 getrennt. Gegebenenfalls kann das Trennen auch vor dem Befestigen erfolgen. Die Halbleiterkörper 4a, die nicht mit dem Anschlussträgerverbund 100 verbunden sind, verbleiben auf dem Halbleiterkörperträger 201.

Die auf dem Halbleiterkörperträger verbleibenden Halbleiterkörper können unter Anwendung des Verfahrens auf einem weiteren Anschlussträgerverbund befestigt werden. Durch selektives Entfernen von Halbleiterkörpern von dem Halbleiterkörperträger 101 kann also ein Halbleiterwafer mittels verschiedener Anschlussträgerverbunde sukzessive "abgeerntet" werden. Dabei werden diejenigen Halbleiterkörper, welche sich über einen Montagebereich des jeweiligen Anschlussträgerverbundes erstrecken von dem Halbleiterkörperträger getrennt und an dem Anschlussträgerverbund befestigt.

Das selektive Entfernen nur eines Teils der Halbleiterkörper von dem Halbleiterkörperträger kann beispielsweise mittels eines Lasertrenn- oder -ablöseverfahrens erfolgen. Dabei kann eine Grenzfläche zwischen dem abzutrennenden Halbleiterkörper und dem Halbleiterkörperträger mit Laserstrahlung 19 bestrahlt werden. Die Haftung der Halbleiterkörper am Halbleiterkörperträger wird dadurch verringert oder zerstört und die Halbleiterkörper werden vom Halbleiterkörperträger getrennt. Die Laserstrahlung 19 zur Abtrennung der Halbleiterkörper 4 durchstrahlt bevorzugt den Halbleiterkörperträger 201. Der Halbleiterkörperträger ist hierzu zweckmäßigerweise für die Strahlung durchlässig.

Die abzutrennenden Halbleiterkörper 4 können dabei mittels einer Wafermap des Anschlussträgerverbunds 100, aus der die Position der Montagebereiche des Anschlussträgerverbunds erhalten werden kann, einer vorgegebenen Anordnung des Halbleiterkörperträgers und des Anschlussträgerverbundes relativ zueinander und gegebenenfalls einer Wafermap des Halbleiterkörperträgers, aus der die Anordnung der Halbleiterkörper auf dem Halbleiterkörperträger erhalten werden kann, selektiert werden. Die jeweilige Wafermap wird zweckmäßigerweise zuvor ermittelt und geeignet gespeichert. Die Strahlung 19 kann auf diese Weise selektiv auf diejenigen Halbleiterkörper gerichtet werden, die vom Halbleiterkörperträger zu trennen sind und insbesondere bereits zuvor am Anschlussträgerverbund 100 befestigt wurden.

Der Halbleiterkörperträger 201 mit den nicht auf den Anschlussträgerverbund 100 übertragenen Halbleiterkörpern 4a kann daraufhin entfernt werden. Die verbleibenden Halbleiterkörper 4a können an einem weiteren Anschlussträgerverbund befestigt werden (nicht dargestellt).

Die Spiegelschicht 8 ist nach dem Befestigen der Halbleiterkörper an dem Anschlussträgerverbund 100 zwischen dem jeweiligen Halbleiterkörper und dem Anschlussträger 12, insbesondere zwischen dem Halbleiterkörper und dem diesem Halbleiterkörper zugeordneten Anschlussbereich 104, angeordnet. Der Halbleiterkörper ist mit diesem Anschlussbereich 104 zweckmäßigerweise elektrisch leitend verbunden.

Nach dem Entfernen des Halbleiterkörperträgers 201 ist die vom Montagebereich abgewandte Seite der an dem Anschlussträgerverbund befestigten Halbleiterkörper für weitere Prozessschritte zugänglich, Figur 3C. Die Halbleiterkörper können auf dieser Seite z. B. beschichtet werden.

Es kann eine Passivierungsschicht 17 auf den Anschlussträgerverbund 100 und insbesondere die Halbleiterkörper 4 aufgebracht werden. Die Passivierungsschicht schützt mit Vorteil den Halbleiterkörper 4. Die Passivierungsschicht 17 kann zunächst vollflächig auf den Anschlussträgerverbund aufgebracht werden und nachfolgend bereichsweise, insbesondere von der von dem Montagebereich, abgewandten Seite der Halbleiterkörper 4 für eine elektrische Kontaktbildung zum Halbleiterkörper, abgetragen werden.

Weiterhin kann in oder auf den Halbleiterkörpern 4 eine Struktur, insbesondere eine Auskoppelstruktur, mittels derer eine Totalreflexion im Halbleiterkörper gestört werden kann, ausgebildet werden (nicht explizit dargestellt). Die aus dem Halbleiterkörper tretende Strahlungsleistung kann so erhöht werden. Die dem Montagebereich abgewandte Seite des Halbleiterkörpers 4 kann hierzu beispielsweise geätzt werden.

Ferner kann auf den Anschlussträgerverbund 100 eine Formmasse 90, insbesondere für eine Planarisierungsschicht, aufgebracht werden, z. B. ein BCB. Die Formmasse für die Planarisierungsschicht kann auf den Anschlussträgerverbund aufgeschleudert werden. Die aufgebrachte Formmasse wird zweckmäßigerweise gehärtet.

Ein sich über die von dem Montagebereich abgewandte Seite der Halbleiterkörper erstreckender Teil der Formmasse kann vor oder nach dem Verfestigen der Formmasse vom Verbund entfernt werden.

Die Formasse kann zunächst vollflächig auf den Anschlussträgerverbund aufgebracht werden und nachfolgend bereichsweise entfernt werden, so dass im jeweiligen Bauelementbereich eine Formmassenschicht vorgesehen ist.

Die Planarisierungsschicht 13 kann sich über die Anschlussleiterschicht 1 erstrecken. Die Planarisierungsschicht ist 13 neben dem jeweiligen Halbleiterkörper 4 angeordnet. Die Planarisierungsschicht 13 setzt die dem Montagebereich abgewandte Oberfläche der Halbleiterkörper 4 bevorzugt eben fort.

Mittels einer Planarisierungsschicht kann das Oberflächenprofil des Anschlussträgerverbunds, insbesondere der auf den Anschlussträger aufgebrachten Teile des Verbunds, geglättet werden. Nachfolgende, in planarer Technik auszuführende Verfahrensschritte werden durch ein geglättetes Oberflächenprofil erleichtert.

Eine Planarisierungsschicht 13 kann gegebenenfalls auch durch eine dicke Passivierungsschicht 17, z. B. mit einer Dicke von 2 µm oder mehr, bevorzugt von 3 µm oder mehr, besonders bevorzugt von 5µm oder mehr, ausgebildet werden (nicht dargestellt). Auf eine gesonderte Planarisierungsschicht, z. B. aus der Formmasse, kann dann verzichtet werden.

Bei einem (aufwachs)substratlosen epitaktisch gewachsenen Halbleiterkörper, einer dünnen Befestigungsschicht und der vorzugsweise dünnen Spiegelschicht weist das Oberflächenprofil mit Vorzug keine ausgeprägten Erhebungen, z. B. von 15 µm oder mehr, auf. Eine Planarisierungsschicht mit den oben für die Passivierungsschicht genannten Dicken kann bereits für eine ausreichende Glättung des Oberflächenprofils sorgen.

Daraufhin wird - vorzugsweise nach dem Vorsehen der Planarisierungsschicht 13 - ein elektrischer Kontakt 11 auf die vom Montagebereich abgewandte Seite des jeweiligen Halbleiterkörpers 4 aufgebracht, insbesondere abgeschieden, z. B. aufgedampft oder aufgesputtert.

Der Kontakt 11 kann lithographisch mittels einer Maske abgeschieden werden (nicht explizit dargestellt). Der Kontakt 11 wird bevorzugt so aufgebracht, dass ein Teil der vom Montagebereich abgewandten Oberfläche des Halbleiterkörpers für den Strahlungsdurchtritt nicht mit dem Kontakt 11 bedeckt ist. Der Kontakt 11 kann als Schicht aufgebracht werden. Der Kontakt kann eine Dicke von 10 µm oder weniger, bevorzugt von 5 µm oder weniger, besonders bevorzugt von 3 µm oder weniger, z. B. von 2 µm oder weniger oder 1 µm oder weniger, aufweisen. Beispielsweise kann der Kontakt eine Dicke von 1 µm aufweisen.

Der Kontakt 11 kann sich von dem Halbleiterkörper ausgehend über die vom Anschlussträger abgewandte Seite der Planarisierungsschicht erstrecken. Die Gefahr eines Risses in dem Kontakt beim Überschreiten des Randes des Halbleiterkörpers 4 wird durch das geglättete Oberflächenprofil vermindert.

Der Kontakt 11 kann als Metallisierung ausgeführt sein. Der Kontakt 11 kann eines oder eine Mehrzahl von Metallen, z. B. Au, Pt und/oder Ti enthalten. Der Kontakt 11 kann nach dem Aufbringen gegebenenfalls galvanisch verstärkt werden.

Eine externe elektrische Anschlussfläche 16 des herzustellenden Bauelements kann mittels eines freiliegenden Bereichs des Kontakts 11 gebildet sein. Eine weitere externe elektrische Anschlussfläche 15 des herzustellenden Bauelements kann mittels eines freiliegenden, insbesondere nicht mit der Planarisierungsschicht 13 bedeckten, Bereichs der, gegebenenfalls galvanisch verstärkten, Anschlussleiterschicht 1 gebildet sein.
Auf den Anschlussträgerverbund und insbesondere die Halbleiterkörper 4, z. B. auf den jeweiligen Kontakt 11, kann nachfolgend ein Lumineszenzkonversionselement 20 aufgebracht werden. Das Lumineszenzkonversionselement enthält bevorzugt einen Leuchtstoff, z. B. Leuchtstoffpartikel. Mittels des Lumineszenzkonversionselements kann im aktiven Bereich erzeugte Strahlung in Strahlung einer anderen Wellenlänge umgewandelt werden. Das herzustellende Bauelement kann mischfarbiges, vorzugsweise weißes, Licht abstrahlen. Das mischfarbige Licht kann Beiträge der im aktiven Bereich erzeugten Strahlung und der vom Lumineszenzkonversionselement konvertierten Strahlung aufweisen. Das Lumineszenzkonversionselement kann als Schicht auf den Halbleiterkörper aufgebracht werden. Für das Aufbringen eignet sich z. B. ein lithographisches Verfahren, insbesondere ein photolithographisches Verfahren. Mittels einer Maske können die Lumineszenzkonversionselemente auf dem jeweiligen Halbleiterkörper platziert werden.

Geeignete Lumineszenzkonversionselemente sind in der WO 98/12757 beschrieben. Weiterhin kann ein optisches Element 21, vorzugsweise ein optisches Element zur Strahlformung, wie eine Linse, auf den Anschlussträgerverbund 100 und insbesondere die Halbleiterkörper 4, z. B. auf den jeweiligen Kontakt 11 und/oder auf das Lumineszenzkonversionselement 20, aufgebracht werden. Die optischen Element können als diskrete Elemente oder als Elementverbund mit einer Mehrzahl von optischen Elementbereichen aufgebracht werden (nicht explizit dargestellt). Ein Elementverbund wird dabei zweckmäßigerweise nach dem Aufbringen in eine Mehrzahl von optischen Elementen, die jeweils einen optischen Elementbereich aufweisen aufgeteilt.
Das Lumineszenzkonversionselement 20 und/oder das optische Element 21 kann auf dem Kontakt 11 angeordnet sein. Das Lumineszenzkonversionselement 20 und/oder das optische Element 21 kann über dem jeweiligen Halbleiterkörper 4 lokalisiert sein.

Daraufhin kann der Anschlussträgerverbund 100 in eine Mehrzahl optoelektronischer Bauelemente 10 aufgeteilt werden. Dies kann durch Entfernen des Hilfsträgers 107 von dem Anschlussträgerverbund erfolgen (nicht explizit dargestellt).

Die Spiegelschicht 8 ist zwischen dem Anschlussträger 12 und dem Halbleiterkörper 4 angeordnet. Der Strahlungsaustritt aus dem Halbleiterkörper erfolgt über die dem Anschlussträger abgewandte Seite des Halbleiterkörpers. Durch die Spiegelschicht kann strahlungsaustrittsseitig eine hohe Strahlungsleistung erzielt werden.

Die externen Anschlussflächen 15, 16 des Bauelements 10 liegen insbesondere auf verschiedenen Ebenen. Die Anschlussfläche 15 kann in der Ebene des Anschlussträgers 12 und die Anschlussfläche 16 in der Ebene der Planarisierungsschicht liegen. Weiterhin liegen beide Anschlussflächen auf der Seite des Anschlussträgers 12, auf der der Halbleiterkörper angeordnet ist.

Die gleichzeitige Verbundfertigung einer Mehrzahl von Bauelementen gemäß den oben beschriebenen Verfahren ist äußerst kostengünstig. Einzelbearbeitungsschritte können weitgehend oder vollständig vermieden werden.

Mittels des oben im Zusammenhang mit Figur 3 beschriebenen Verfahrens können nicht nur Bauelemente 10 hergestellt werden, deren externe Anschlussflächen 15, 16 auf verschiedenen Ebenen liegen. Vielmehr kann sich ein Kontaktleiter, der mit der vom Montagebereich abgewandten Seite des Halbleiterkörpers elektrisch leitend verbunden ist, von dieser Seite in Richtung der dem Halbleiterkörper zugewandten Seite des Anschlussträgers erstrecken. Der Kontaktleiter kann auf dieser Seite des Anschlussträgers elektrisch leitend mit einem auf dem Anschlussträger ausgebildeten zusätzlichen Anschlussbereich verbunden sein.

Insbesondere kann ein Anschlussträger 12 eingesetzt werden, auf dem zwei elektrische Anschlussbereiche ausgebildet sind, die voneinander elektrisch isoliert sind.

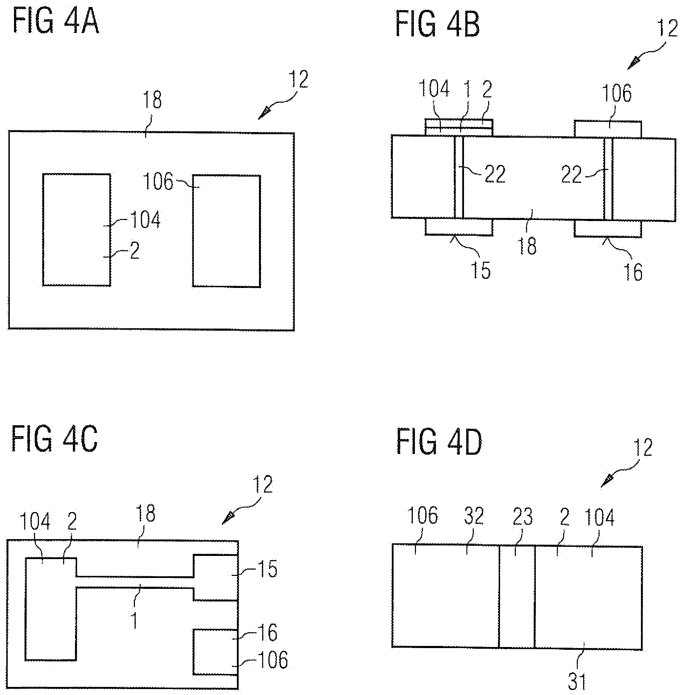

Figur 4 zeigt in den Figuren 4A bis 4D verschiedene Anschlussträger anhand verschiedener schematischer Ansichten. Diese Anschlussträger können in einem oben beschriebenen Verfahren eingesetzt werden.

Die Anschlussträger 12 weisen jeweils zwei elektrische Anschlussbereiche 104, 106 auf, die elektrisch voneinander isoliert sind. Dabei kann ein Anschlussbereich 104 für die Befestigung des Halbleiterkörpers auf dem Anschlussbereich vorgesehen sein. Der Halbleiterkörper wird mit diesem Anschlussbereich zweckmäßigerweise elektrisch leitend verbunden. Der zur Montage des Halbleiterkörpers vorgesehene Anschlussbereich kann, mit Vorzug im Gegensatz zu dem anderen Anschlussbereich, mit der Befestigungsschicht 2 versehen sein.

Alternativ kann der Halbleiterkörper auch neben beiden Anschlussbereichen auf dem Anschlussträger befestigt werden (nicht explizit dargestellt). Der Montagebereich ist dann zweckmäßigerweise kein Teil des Anschlussbereichs. Eine elektrisch leitende Verbindung des Halbleiterkörpers mit den Anschlussbereichen kann nach der Montage des Halbleiterkörpers erfolgen. Kontakte können mittels des in Figur 3 beschriebenen Verfahrens auf die vom Montagebereich abgewandte Seite des Halbleiterkörpers aufgebracht werden. Für die elektrische Kontaktbildung werden z. B. Kontaktleiter zu den Anschlussbereichen 104, 106 geführt.

Die anhand der Figuren 4A, 4B und 4C schematisch dargestellten Anschlussträger 12 weisen jeweils einen elektrisch isolierenden Trägerkörper 18, z. B. einen Keramikkörper oder einen Siliziumkörper, auf, auf dem die Anschlussbereich 104, 106 angeordnet sind. Die Anschlussbereiche sind weiterhin zweckmäßigerweise auf der gleichen Seite des Anschlussträgers angeordnet.

Eine Dicke des jeweiligen Anschlussträgers kann 100 µm oder weniger oder 50 µm oder weniger, bevorzugt 40 µm oder weniger, besonders bevorzugt 30 µm oder weniger, betragen.

Figur 4B kann dabei eine Schnittansicht durch den Anschlussträger gemäß Figur 4A darstellen. Dabei ist der Trägerkörper 18 bereichsweise ausgespart und weist einen Verbindungsleiter 22 auf, der sich von der Seite des Trägerkörpers mit den Anschlussbereichen bis zu der dieser Seite gegenüberliegenden Seite erstreckt. Über den Verbindungsleiter (sogenannte "Via") kann der Anschlussbereich mit einer auf der vom Anschlussbereich abgewandten Seite des Trägerkörpers angeordneten externen Anschlussfläche 15 verbunden sein. Diese Fläche kann z. B. als Lotfläche ausgeführt sein. Analog kann der zweite Anschlussbereich 106 über einen Verbindungsleiter mit einer zweiten Anschlussfläche 16 verbunden sein.

Gemäß der Aufsicht in Figur 4C ist die erste Anschlussfläche 15 auf der den Anschlussbereichen 104, 106 zugewandten Seite des Trägerkörpers 18 angeordnet. Die zweite Anschlussfläche 16 kann ebenfalls auf der den Anschlussbereichen zugewandten Seite des Trägerkörpers 18 angeordnet sein.

Der Anschlussträger 12 gemäß der Aufsicht in Figur 4D weist zwei elektrisch leitfähige Körper 31, 32 auf, z. B. zwei Metallkörper oder Metallverbindungskörper, etwa aus Cu oder CuWo. Metalle zeichnen sich ebenso wie Keramiken in der Regel durch hohe thermische Leitfähigkeiten aus. Die Körper 31, 32 sind, z. B. über eine elektrisch isolierende Verbindungsschicht 23, miteinander verbunden, z. B. verklebt, und insbesondere elektrisch voneinander isoliert. Die Anschlussbereiche 104, 106 können mittels der Oberfläche des Körpers 31 bzw. 32 gebildet sein. Auf ein gesondertes Ausbilden von Anschlussbereichen mittels einer Anschlussleiterschicht 1 kann verzichtet werden. Soll ein Halbleiterkörper auf einem Anschlussbereich montiert werden, ist es zweckmäßig, diesen Anschlussbereich mit der Befestigungsschicht 2 zu versehen. Die Anschlussflächen 15, 16 können auf der den Anschlussbereichen 104, 106 abgewandten Seite des Anschlussträgers ausgebildet sein.

Besonders zweckmäßig ist es, in dem Verfahren zur Herstellung von optoelektronischen Bauelementen gemäß Figur 3 nicht gesonderte Anschlussträger 12 einzusetzen, sondern eine Anschlussträgerschicht 101 zu verwenden, die eine Mehrzahl von Bauelementbereichen 102 aufweist. Auf einen Hilfsträger 107 kann dann in dem Verfahren verzichtet werden.

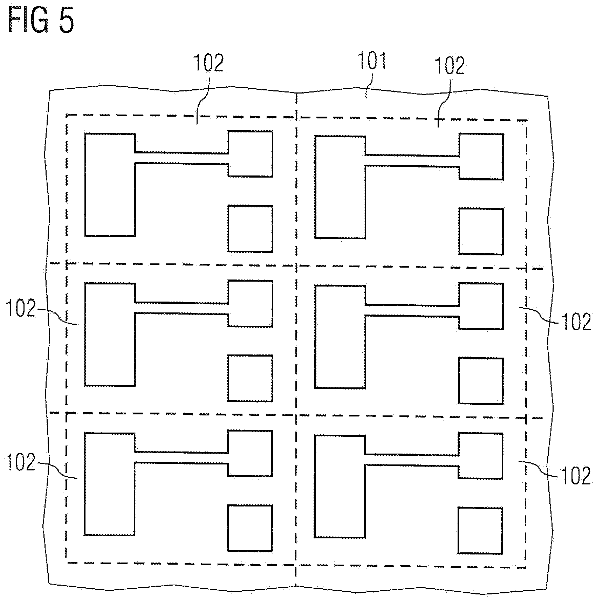

Figur 5 zeigt eine Teilaufsicht auf eine derartige Anschlussträgerschicht 101. Der jeweilige Bauelementbereich entspricht dabei dem in Figur 4C dargestellten Anschlussträger 12. Eine Anschlussträgerschicht kann jedoch auch für anders ausgestaltete Anschlussträger 12, z. B. die in Figur 4 dargestellten Anschlussträger, ausgebildet sein.

Die Anschlussträger 12 der einzelnen Bauelemente 10 werden dann beim Aufteilen des Anschlussträgerverbundes in Bauelemente gebildet. Die Anschlussträgerschicht 101 kann hierzu entlang der gestrichelten Linien, die z. B. jeweils einen Bauelementbereich 102 umgrenzen, durchtrennt werden. Das Durchtrennen der Anschlussträgerschicht, die beispielsweise eine Keramik umfasst, für das Ausbilden der Bauelemente kann mittels eines Lasers erfolgen. Alternativ oder ergänzend können in der Anschlussträgerschicht 101 Solltrennbereiche ausgebildet sein, die den jeweiligen Bauelementbereich, z. B. entlang der gestrichelten Linien, vorzugsweise umgeben. Ein Solltrennbereich kann beispielsweise durch eine Perforation der Anschlussträgerschicht oder eine Einkerbung der Anschlussträgerschicht ausgebildet sein.

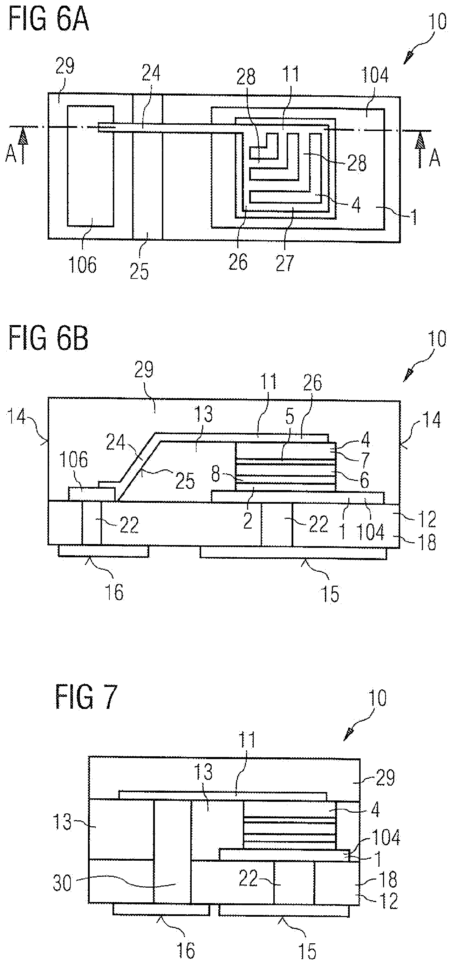

Figur 6 zeigt anhand einer schematischen Aufsicht in Figur 6A und einer schematischen Schnittansicht in Figur 6B entlang der Linie A-A aus Figur 6A ein Ausführungsbeispiel eines optoelektronischen Bauelements. Das Bauelement kann in dem im Zusammenhang mit Figur 3 beschriebenen Verfahren hergestellt werden.

Das Bauelement 10 entspricht im Wesentlichen dem gemäß Figur 3 hergestellten Bauelement. Im Unterschied hierzu erstreckt sich ein Kontaktleiter 24 von der vom Anschlussträger 12 abgewandten Seite des Halbleiterkörpers 4 zum Anschlussträger 12 hin. Der Kontakt 11 umfasst mit Vorzug den Kontaktleiter 24. Der Kontaktleiter erstreckt sich quer, insbesondere schräg, zum aktiven Bereich bzw. dem Anschlussträger entlang des Halbleiterkörpers 4.

Neben dem Halbleiterkörper ist die Planarisierungsschicht 13 angeordnet. Der Kontaktleiter 24 kann entlang einer Schräge 25 der Planarisierungsschicht 13 geführt werden. Die Schräge ist mit Vorzug an der vom Halbleiterkörper entfernten Seite der Planarisierungsschicht 13 ausgebildet.

Der Kontaktleiter 24 kann sich über die Planarisierungsschicht 13 vom Halbleiterkörper beabstandet entlang des Halbleiterkörpers erstrecken. Der Kontaktleiter ist weiterhin mit einem auf dem Anschlussträger ausgebildeten, insbesondere auf der dem Halbleiterkörper zugewandten Seite angeordneten, Anschlussbereich 106 verbunden. Entlang der Planarisierungsschicht kann der Kontaktleiter zur Ebene des Anschlussträgers geführt werden.

Durch die Schräge 25 wird die Gefahr einer Durchtrennung des Kontaktleiters 24 gemindert. Aufgrund des ohnehin sehr flachen Oberflächenprofils ist eine Schräge nicht unbedingt erforderlich.

Gegebenenfalls kann auf den Halbleiterkörper eine Passivierungsschicht aufgebracht sein (nicht explizit dargestellt). Ist diese hinreichend dick ausgebildet, kann auf eine zusätzliche Planarisierungsschicht verzichtet werden. Eine zusätzliche Planarisierungsschicht kann trotz der Passivierungsschicht vorgesehen sein.

Der Kontaktleiter 24 kann noch im Anschlussträgerverbund auf den Verbund aufgebracht, insbesondere abgeschieden, werden.

Die Schräge 25 kann nach dem Aufbringen von Material für die Planarisierungsschicht in dem Verfahren gemäß Figur 1, z. B. durch Abtragen des Materials für die Schräge, ausgebildet werden. Alternativ kann das Material für die Planarisierungsschicht auch bereits geeignet strukturiert auf den Verbund aufgebracht werden.

Über den Kontaktleiter 24 ist die dem Anschlussträger 12 abgewandte Seite des Halbleiterkörpers 4 mit der externen Anschlussfläche 16 elektrisch leitend verbunden. Der Kontaktleiter kann hierzu mit dem neben dem Halbleiterkörper auf dem Anschlussträger angeordneten Anschlussbereich 106 elektrisch leitend verbunden sein. Die Planarisierungsschicht 13 kann als Kontaktrampe ausgebildet sein. Die Planarisierungsschicht 13 kann sich vom Anschlussträger ausgehend mit wachsender Entfernung vom Anschlussträger verjüngen.

Die auf der vom Halbleiterkörper abgewandten Seite des Anschlussträgers 12 angeordneten externen Anschlussflächen 15, 16 sind zweckmäßigerweise über Verbindungsleiter 22, die sich durch den elektrisch isolierenden Trägerkörper 18 erstrecken, mit dem jeweiligen Anschlussbereich 104 bzw. 106 elektrisch leitend verbunden. Das Bauelement 10 ist insbesondere als oberflächenmontierbares Bauelement ausgebildet.

Der sich über den Halbleiterkörper erstreckende Teil des Kontakts 11 weist weiterhin eine Stromverteilungsstruktur 26 auf. Über die Stromverteilungsstruktur können Ladungsträger großflächig über den Halbleiterkörper verteilt werden. Dem aktiven Bereich können so homogen Ladungsträger zugeführt werden, welche dort unter Strahlungserzeugung rekombinieren können.

Die Stromverteilungsstruktur 26 kann einen Rahmen 27 umfassen. Von dem Rahmen 27 kann eine oder eine Mehrzahl von Ableitungen 28 abzweigen. Die Stromverteilungsstruktur ist für den Strahlungsdurchtritt weiterhin bereichsweise, z. B. L-förmig, ausgespart. Absorption von Strahlung in der, z. B. metallischen, Stromverteilungsstruktur 26 kann so gemindert werden.

Der Kontakt 11 kann - inklusive des Kontaktleiters und der Stromverteilungsstruktur - eine durchgehende Schicht umfassen. Insbesondere kann der Kontakt mittels Lithographie, z. B. Photolithographie, unter Einsatz einer einzigen Maske, z. B. einer Photo(lack)maske, auf den Halbleiterkörper 4 aufgebracht, insbesondere abgeschieden, sein.

Der Kontakt 11, z. B. der Kontaktleiter und/oder die Stromverteilungsstruktur, kann, insbesondere durchgehend, eine Dicke von 10 µm oder weniger, bevorzugt von 8 µm oder weniger, besonders bevorzugt von 5 µm oder weniger, z. B. 2 µm oder weniger oder 1 µm oder weniger aufweisen. Um die Stromtragfähigkeit zu erhöhen kann der Kontakt gegebenenfalls galvanisch verstärkt sein. Auf ein dickes Bondpad, welches bei herkömmlichen Halbleiterchips für die Kontaktierung eingesetzt wird und auf einen Bonddraht kann verzichtet werden.

Auf der vom Anschlussträger abgewandten Seite des Halbleiterkörpers ist mit Vorzug eine, zweckmäßigerweise strahlungsdurchlässige, Verkapselung 29 angeordnet. Diese kann z. B. ein Acryl-, ein Epoxid- oder ein Silikonharz oder ein Silikon enthalten. In die Verkapselung können Lumineszenzkonversionspartikel eingebettet sein. Die Verkapselung kann sich, vorzugsweise vollständig, über die vom Anschlussträger abgewandte Seite des Kontakts 11, des Anschlussbereichs 106, des Anschlussbereichs 104, und/oder des Halbleiterkörpers 4 erstrecken. Die Verkapselung kann die Elemente des Bauelements vor schädlichen äußeren Einflüssen schützen.

Material für die Verkapselung kann auf den Anschlussträgerverbund aufgebracht werden. Beim Aufteilen des Anschlussträgerverbunds in Bauelemente kann eine durchgehende Verkapselungsschicht für die Verkapselung durchtrennt werden. Das Bauelement 10 kann vereinzelte Seitenflächen 14 aufweisen.

Figur 7 zeigt ein weiteres Ausführungsbeispiel eines optoelektronischen Bauelements anhand einer schematischen Schnittansicht.

Das Bauelement 10 entspricht im Wesentlichen dem im Zusammenhang mit Figur 6 beschriebenen Bauelement. Im Unterschied hierzu ist nur ein Anschlussbereich 104 auf dem Anschlussträger 12 vorgesehen. Auf eine Führung des Kontakts 11 zum Anschlussträger ist verzichtet. Für die externe elektrische Kontaktbildung zum Halbleiterkörper ist die Planarisierungsschicht 13 ausgespart. Ein Verbindungsleiter 30 erstreckt sich im Bereich der Aussparung durch die Planarisierungsschicht und ist elektrisch leitend mit dem Kontakt 11 und insbesondere der externen elektrischen Anschlussfläche 16 verbunden. Der Kontakt 11 erstreckt sich dazu zweckmäßigerweise zumindest bereichsweise über die Aussparung in der Planarisierungsschicht 13.

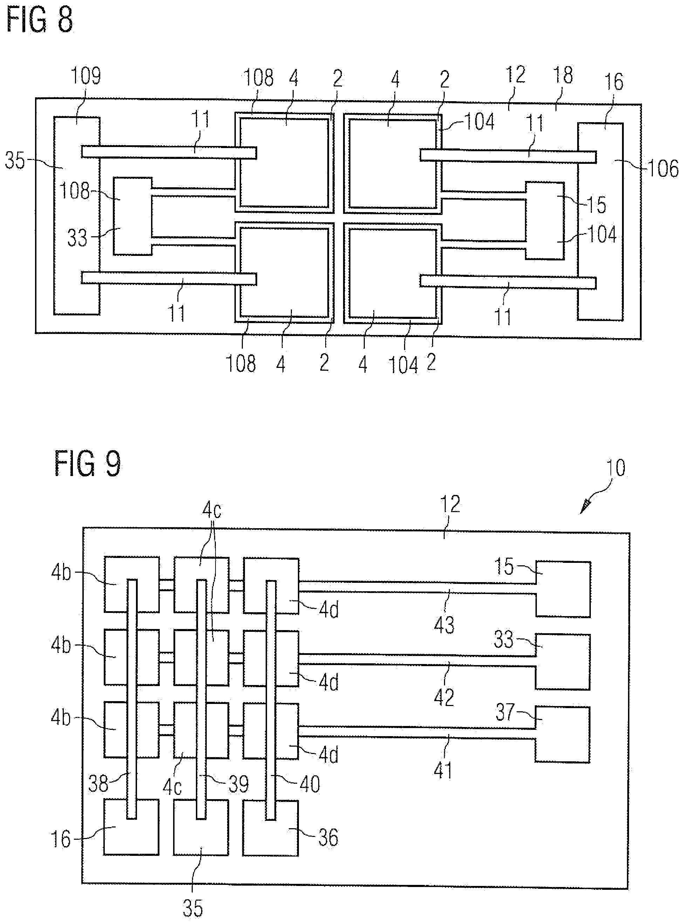

Figur 8 zeigt ein weiteres Ausführungsbeispiel für ein optoelektronisches Bauelement anhand einer schematischen Aufsicht. Das Bauelement 10 weist eine Mehrzahl von nebeneinander auf dem Anschlussträger 12 angeordneten und auf diesem befestigten Halbleiterkörpern 4 auf.

Die Halbleiterkörper 4 sind auf einem dem jeweiligen Halbleiterkörper zugeordneten Anschlussbereich 104, 108 befestigt und über die Anschlussbereiche mit einer neben den Halbleiterkörpern angeordneten externen Anschlussfläche 15 bzw. 33 elektrisch leitend verbunden. Weiterhin sind die Halbleiterkörper jeweils über einen Kontakt 11 mit einer weiteren auf dem Anschlussträger 12 ausgebildeten externen Anschlussfläche 16 bzw. 35, insbesondere einem weiteren Anschlussbereich 16 bzw. 109, elektrisch leitend verbunden. Ein Abstand der Halbleiterkörper kann dem Abstand entsprechen, den die Halbleiterkörper 4 auf dem Halbleiterkörperträger hatten, da die Halbleiterkörper in dem Verfahren direkt auf den Anschlussträger(verbund) übertragen werden können. Insbesondere kann der Abstand benachbarter Halbleiterkörper 5 µm oder weniger, z. B. 2 µm betragen.

Die Abstände der Montagebereiche sind hierzu bevorzugt an die der Halbleiterkörper auf dem Halbleiterkörperträger angepasst. Die Montagebereiche können gegebenenfalls auch derart ausgebildet werden, dass der jeweilige Halbleiterkörper den ihm zugeordneten Montagebereich vollständig überdeckt (nicht explizit dargestellt). Ein Abstand der Montagebereiche (der Befestigungsschichten 2) voneinander ist dazu zweckmäßigerweise größer gewählt als der Abstand der Halbleiterkörper auf dem Halbleiterkörperträger. Mit Vorzug ist der Abstand der Montagebereiche jedoch klein genug gewählt, dass auf dem Halbleiterkörper benachbarte Halbleiterkörper auch auf benachbarte Montagebereiche des gemeinsamen Bauelementbereichs des Anschlussträgerverbundes übertragen werden können.

Figur 9 zeigt ein weiteres Ausführungsbeispiel eines optoelektronischen Bauelements 10 anhand einer schematischen Aufsicht.

Das Bauelement weist eine Mehrzahl von Halbleiterkörpern 4b, 4c und 4d auf. Diese können zueinander Abstände analog den Halbleiterkörpern gemäß Figur 8 aufweisen. Die Halbleiterkörper sind vorzugsweise zur Erzeugung von Strahlung in verschiedenfarbigen Spektralbereichen, insbesondere in den Spektralbereichen von drei Grundfarben ausgebildet. Die Halbleiterkörper 4b können für rote, die Halbleiterkörper 4c für grüne und die Halbleiterkörper 4d für blaue Strahlung ausgebildet sein. Ein Halbleiterkörpertripel (4b, 4c, 4d) kann ein Pixel für eine Bildanzeigevorrichtung bilden. Die Halbleiterkörper können aufgrund des direkten Transfers von einem Wafer vorteilhaft dicht gepackt sein. Aufgrund der Spiegelschicht, die entsprechend den vorhergehenden Figuren zweckmäßigerweise zwischen dem jeweiligen Halbleiterkörper und der diesem Halbleiterkörper zugeordneten Befestigungsschicht angeordnet ist, ist die austrittsseitige Leuchtdichte der einzelnen Halbleiterkörper vorteilhaft groß. Aufgrund der dichten Anordnung der Halbleiterkörper nebeneinander kann die Leuchtdichte aus einer alle Halbleiterkörper überdeckenden virtuellen Fläche erhöht werden.

Die Halbleiterkörper sind mit Vorzug matrixartig in Zeilen und Spalten angeordnet. Über Zeilenleitungen 41, 42, 43, die jeweils mit den Halbleiterkörpern 4d, 4c, 4b einer Zeile elektrisch leitend verbunden sind, und über Spaltenleitungen 38, 39, 40, die jeweils mit den Halbleiterkörpern einer Spalte elektrisch leitend verbunden sind, können die Halbleiterkörper einzeln angesteuert werden. Die Zeilenleitung 41, 42 bzw. 43 ist mit der Anschlussfläche 15, 33 bzw. 37 und die Spaltenleitung 38, 39 bzw. 40 ist mit der Anschlussfläche 16, 35 bzw. 36 elektrisch leitend verbunden.

Die Zeilenleitungen können gegebenenfalls zusammen mit der jeweils zugehörigen Anschlussfläche lithographisch auf dem Anschlussträger ausgebildet werden. Die Spaltenleitungen können lithographisch - auf analoge Weise wie die Kontakte 11 (siehe weiter oben) - ausgebildet werden. Gegebenenfalls können die Spaltenleitungen und die jeweils zugehörige Anschlussfläche mittels Lithographie unter Einsatz einer gemeinsamen Maske ausgebildet werden.

Den Halbleiterkörpern kann auf der vom Anschlussträger 12 abgewandten Seite gegebenenfalls eine Optik, z. B. für ein Projektionsgerät, nachgeordnet werden (nicht explizit dargestellt).

Da die Halbleiterkörper im Rahmen der Verfahren direkt von dem Halbleiterkörperträger, z. B. dem Aufwachssubstrat, auf den Anschlussträgerverbund übertragen werden, können die Halbleiterkörper frei geformt werden. Insbesondere können Halbleiterkörper, welche mit herkömmlichen Bestückungsautomaten, beispielsweise für eine Pick and Place-Bestückung, nicht oder nur schwer gehandhabt werden können, in dem vorgeschlagenen Verfahren ohne Schwierigkeiten für Bauelemente verarbeitet werden.

Ein Halbleiterkörper kann beispielsweise in Erstreckungsrichtung des aktiven Bereichs eine Querabmessung, z. B. eine Breite, von 50 µm oder weniger, bevorzugt 40 µm oder weniger, besonders bevorzugt 30 µm oder weniger, z. B. 20 µm oder weniger oder 10 µm oder weniger aufweisen. Eine Längsabmessung, z. B. eine Länge, des Halbleiterkörpers entlang des aktiven Bereichs kann 1 mm oder mehr, bevorzugt 2 mm oder mehr besonders bevorzugt 5 mm oder, z. B. 8 mm oder mehr oder 10 mm oder mehr, betragen.

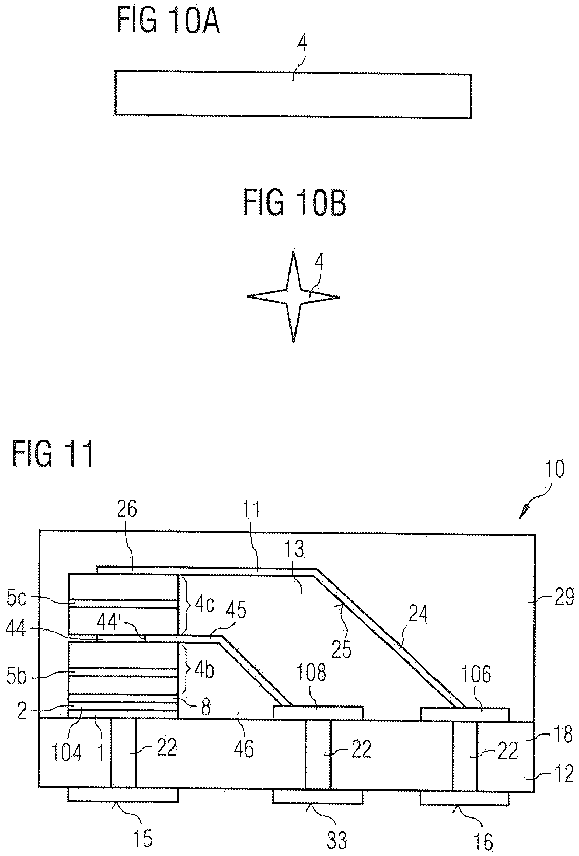

Der Halbleiterkörper 4 kann einen rechteckigen Grundriss und insbesondere eine Quaderform aufweisen (vgl. die Aufsicht in Figur 10A). Eine derartige Formgebung ist für eine hohe Auskoppeleffizienz von Strahlung besonders vorteilhaft.

Auch noch unkonventionellere Formgebungen für Halbleiterkörper können im Rahmen der oben beschriebenen Verfahren ohne Probleme für Bauelemente verarbeitet werden (vgl. z. B. den Halbleiterkörper mit sternförmigem Grundriss in Figur 10B).

Weiterhin können die Halbleiterkörper für die Bauelemente hinsichtlich ihrer Abmessungen mit Vorteil im Wesentlichen frei skaliert werden. Anschlussbereiche in den Bauelementbereichen des Anschlussträgerverbundes können unabhängig von der Ausbildung der Halbleiterkörper ausgestaltet werden, da die Kontaktierung der Halbleiterkörper - z. B. mittels des Kontaktes 11 - in einem planaren Prozess mittels der Planarisierungsschicht erfolgen kann. Insbesondere kann der jeweilige Kontakt entlang der Planarisierungsschicht zu dem jeweiligen Anschlussbereich geführt werden.

Es sei angemerkt dass der Halbleiterkörper nicht notwendigerweise auf einem elektrischen Anschlussbereich montiert und kontaktiert werden muss. Vielmehr kann auch ein Halbleiterkörper in einem Bauelement eingesetzt werden, der auf verschiedenen Seiten des aktiven Bereichs elektrisch kontaktiert wird, wobei sich beide Kontakte, vorzugsweise entlang der Planarisierungsschicht, von der vom Anschlussträger abgewandten Seite des Halbleiterkörpers ausgehend in Richtung des Anschlussträgers erstrecken und dort gegebenenfalls mit einem Anschlussbereich verbunden sind. Ein derartiger Halbleiterkörper wird zweckmäßigerweise unmittelbar auf dem Trägerkörper 18 montiert.

Figur 11 zeigt ein weiteres Ausführungsbeispiel eines optoelektronischen Bauelements anhand einer schematischen Schnittansicht.

Das Bauelement 10 entspricht im Wesentlichen den im Zusammenhang mit den vorhergehenden Figuren beschriebenen Bauelementen. Im Unterschied hierzu ist bei dem Bauelement gemäß Figur 11 ein Halbleiterkörper 4c auf einem weiteren Halbleiterkörper 4b angeordnet. Dabei ist der Halbleiterkörper 4c vorzugsweise epitaktisch gewachsen und insbesondere (aufwachs)substratlos ausgebildet. Der Halbleiterkörper 4c ist auf der vom Montagebereich des Halbleiterkörpers 4b auf dem Anschlussträger 12 abgewandten Seite des Halbleiterkörpers 4b angeordnet.

Die Halbleiterkörper 4b, 4c sind weiterhin elektrisch leitend verbunden. Hierzu ist zwischen den Halbleiterkörpern ein Verbindungskontakt 44 angeordnet. Über den Verbindungskontakt können die Halbleiterkörper 4b, 4c seriell verschaltet betrieben werden.

Der Halbleiterkörper 4c wird zweckmäßigerweise von im Halbleiterkörper 4b erzeugter Strahlung durchstrahlt. Bei gleichzeitigem Betrieb beider Halbleiterkörper können sich die im jeweiligen Halbleiterkörper erzeugten Strahlungen auf der von dem Montagebereich abgewandten Seite des Halbleiterkörpers 4c zu Mischstrahlung überlagern. Absorptionsverluste in einem (Aufwachs)substrat des Halbleiterkörpers können vermieden werden. Gleichzeitig wird, bei einer (aufwachs)substratlosen Ausführung beider Halbleiterkörper die Bauhöhe vorteilhaft gering gehalten.

Der Verbindungskontakt 44 erstreckt sich bevorzugt nur über einen Teilbereich der vom Anschlussträger abgewandten Oberfläche des Halbleiterkörpers 4b. Der Strahlungsübertritt vom einen Halbleiterkörper in den anderen Halbleiterkörper wird so erleichtert. Der Verbindungskontakt kann hierzu vergleichsweise kleinflächig ausgeführt sein und sich beispielsweise über 50% oder weniger der Oberfläche des Halbleiterkörpers erstrecken.

Alternativ oder ergänzend kann der Verbindungskontakt 44 für den Strahlungsdurchtritt bereichsweise ausgespart sein.

Die aktiven Bereiche 5b, 5c können zur Erzeugung von gleichfarbiger Strahlung und/oder Strahlung der gleichen Wellenlänge ausgebildet sein. Die aus dem Halbleiterkörper 4c austretende Leuchtdichte dieser Strahlung kann so um einen Beitrag der im Halbleiterkörper 4b erzeugten Strahlung erhöht werden.

Alternativ können die Halbleiterkörper 4c und 4b, insbesondere die entsprechenden aktiven Bereiche 5c, 5b, zur Erzeugung von Strahlung verschiedener Wellenlängen, insbesondere in verschiedenfarbigen Spektralbereichen, ausgebildet sein. Zweckmäßigerweise ist der Halbleiterkörper 4b dann zur Erzeugung von Strahlung einer größeren Wellenlänge, z. B. im roten oder grünen Spektralbereich, ausgebildet als der Halbleiterkörper 4c, der z. B. für grüne bzw. blaue Strahlung ausgebildet ist. Absorptionsverluste der Strahlung aus dem Halbleiterkörper 4b im Halbleiterkörper 4c können so verringert oder vermieden werden. Der aktive Bereich 5c, insbesondere der Halbleiterkörper 4c, weist hierzu zweckmäßigerweise eine größere Bandlücke auf als der aktive Bereich 5b. Nach dem Durchstrahlen des Halbleiterkörpers 4c kann so mischfarbige Strahlung, insbesondere weißes Licht, entstehen.

Weiterhin sind die Halbleiterkörper 4b und 4c bevorzugt unabhängig voneinander elektrisch ansteuerbar, so dass entweder der Halbleiterkörper 4b oder der Halbleiterkörper 4c oder beide Halbleiterkörper gemeinsam betrieben werden können.

Dafür ist zweckmäßigerweise ein Kontaktleiter 45, der eine gemeinsame Schicht mit dem Verbindungskontakt 44 aufweisen und insbesondere einstückig mit dem Verbindungskontakt 44 ausgeführt sein kann, elektrisch leitend mit einer externen Anschlussfläche 33 verbunden. Der Kontaktleiter 45 kann mit einem auf dem Anschlussträger ausgebildeten elektrischen Anschlussbereich 108 verbunden sein. Der Kontaktleiter 45 kann mittels einer gegebenenfalls randseitig schräg verlaufenden Planarisierungsschicht 46 in Richtung des Anschlussträgers und insbesondere zu dem Anschlussbereich 108 geführt sein. Der Kontakt 11 des Halbleiterkörpers 4c kann, z. B. mittels einer Planarisierungsschicht 13 zu dem Anschlussträger 12 geführt und mit einer externen Anschlussfläche 16 elektrisch leitend verbunden sein.

Über die Anschlussflächen 15, 16 und 33, die bevorzugt auf der von den Halbleiterkörpern abgewandten Seite des Anschlussträgers angeordnet sind, können die Halbleiterkörper 4b, 4c unabhängig voneinander betrieben werden.

Zur Herstellung eines derartigen Bauelements kann zunächst der Halbleiterkörper 4b auf den Anschlussträgerverbund aufgebracht und von dem entsprechenden Halbleiterkörperträger getrennt werden. Daraufhin wird der Verbindungskontakt, z. B. eine Metallisierung oder eine Metallverbindung aufweisend, auf den auf dem Anschlussträgerverbund befestigten Halbleiterkörper 4b aufgebracht, z. B. abgeschieden. Auf diesen Halbleiterkörper und insbesondere den Verbindungskontakt 44 wird nachfolgend der Halbleiterkörper 4c entweder vom gleichen Halbleiterkörperträger oder einem anderen Halbleiterkörperträger übertragen. Die weiteren Verfahrensschritte können wie oben beschrieben ausgeführt werden.

Selbstverständlich können auf diese Weise auch drei oder mehr Halbleiterkörper aufeinander gestapelt und insbesondere elektrisch leitend miteinander verbunden werden. Besonders zweckmäßig ist eine Anordnung dreier Halbleiterkörper übereinander. Diese können als "Stapel-Pixel" für eine Vollfarbdarstellung ausgebildet sein. Über eine Nebeneinanderanordnung einer Mehrzahl derartiger "Stapel-Pixel" in einem Bauelementbereich kann eine Anzeigevorrichtung, insbesondere eine vollfarbige Bildanzeigevorrichtung, besonders kompakt realisiert werden. Bevorzugt ist in der Abfolge vom Anschlussträger aus gesehen der erste Halbleiterkörper zur Erzeugung roter Strahlung, der zweite zur Erzeugung grüner Strahlung und der dritte Halbleiterkörper zur Erzeugung blauer Strahlung ausgebildet.

Für den Fall, dass die Halbleiterkörper 4b, 4c nur gemeinsam betrieben werden sollen, kann auf den Kontaktleiter 45 verzichtet werden. Der Verbindungskontakt 44 verbindet damit nur die beiden Halbleiterkörper. Ein derartiger Verbindungskontakt kann von den Halbleiterkörpern vollständig überdeckt sein. Insbesondere kann er kleinflächiger als die Halbleiterkörper 4b, 4c ausgeführt sein. Dies ist durch die Linie 44' angedeutet, die den Verbindungskontakt 44 begrenzen kann.

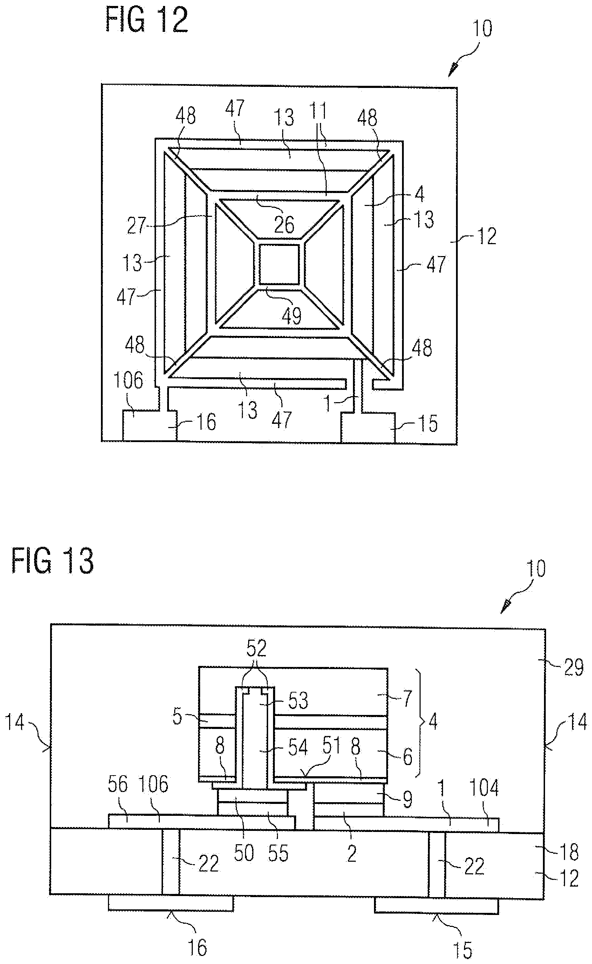

Figur 12 zeigt ein weiteres Ausführungsbeispiel eines optoelektronischen Bauelements anhand einer schematischen Aufsicht.

Das Bauelement 10 entspricht im Wesentlichen den im Zusammenhang mit den vorhergehenden Figuren beschriebenen Bauelementen. Im Unterschied dazu verläuft eine Stromverteilungsleitung 47 in Aufsicht auf den Anschlussträger 12 neben dem Halbleiterkörper 4 und entlang des Halbleiterkörpers. Die Stromverteilungsleitung 47 kann neben mehreren Seiten des Halbleiterkörpers 4 verlaufen. Insbesondere kann die Stromverteilungsleitung allseitig neben dem Halbleiterkörper verlaufen. Die Stromverteilungsleitung 47 verläuft bevorzugt in der Ebene des Anschlussträgers 12. Weiterhin ist die Stromverteilungsleitung bevorzugt mit der externen elektrischen

Anschlussfläche 16 des Bauelements 10 elektrisch leitend verbunden.

Über die Stromverteilungsleitung 47, die den Halbleiterkörper vorzugsweise bahnartig umläuft, können Ladungsträger umfangsseitig um den Halbleiterkörper verteilt werden. Diese Verteilung kann noch auf dem Anschlussträger 12 erfolgen, also bevor die Ladungsträger zu der vom Anschlussträger 12 abgewandten Seite des Halbleiterkörpers 4 geführt werden.

Die Stromverteilungsleitung 47 ist von einem Kontaktelement zur Kontaktierung von der dem Anschlussträger zugewandten Seite des Halbleiterkörpers, z. B. der Anschlussleiterschicht 1 und insbesondere der externen Anschlussfläche 15, zweckmäßigerweise elektrisch isoliert. Für die Kontaktierung der dem Anschlussträger zugewandten Seite des Halbleiterkörpers, z. B. über die Anschlussleiterschicht 1, kann die Stromverteilungsleitung unterbrochen sein, wobei sich die Anschlussleiterschicht zweckmäßigerweise im Bereich der Unterbrechung von der vom Halbleiterkörper abgewandten Seite der Stromverteilungsleitung zu dem Halbleiterkörper erstreckt.

Die Stromverteilungsleitung 47 ist bevorzugt mit der vom Anschlussträger 12 abgewandten Seite des Halbleiterkörpers 4 elektrisch leitend verbunden. Mit der Stromverteilungsleitung 47 kann eine oder eine Mehrzahl von Stromzuleitungen 48 elektrisch leitend verbunden sein. Die (jeweilige) Stromzuleitung 48 erstreckt sich mit Vorzug von der Stromverteilungsleitung ausgehend in Richtung des Halbleiterkörpers und insbesondere bis über die vom Anschlussträger 12 abgewandte Seite des Halbleiterkörpers 4. Die (jeweilige) Stromzuleitung 48 kann entlang einer gegebenenfalls angeschrägten Planarisierungsschicht 13 auf den Halbleiterkörper geführt sein.

Über die Stromzuleitungen 48 können Ladungsträger, welche bereits lateral um den Halbleiterkörper verteilt sind, von mehreren Seiten zum Halbleiterkörper geleitet werden. Die Stromzuleitungen 48 können mit einer auf dem Halbleiterkörper angeordneten Stromverteilungsstruktur 26 elektrisch leitend verbunden sein. Die Stromverteilungsstruktur kann einen Rahmen 27 aufweisen. Bevorzugt weist die Stromverteilungsstruktur 26 einen äußeren Rahmen, den Rahmen 27, und einen inneren Rahmen 49 auf. Der äußere Rahmen kann den inneren Rahmen, insbesondere vollständig, umlaufen. Die Rahmen sind bevorzugt elektrisch leitend miteinander verbunden. Insbesondere kann sich die (jeweilige) Stromzuleitung 48 von dem Rahmen 27 bis zu dem Rahmen 49 erstrecken.

Bevorzugt weisen die Stromverteilungsstruktur 26, insbesondere der Rahmen 27 und/oder der Rahmen 49, die Stromzuleitung(en), die Stromverteilungsleitung 47, der elektrische Anschlussbereich 106 und/oder die externe elektrische Anschlussfläche 16, eine durchgehende Schicht auf. Diese Elemente, insbesondere der Kontakt 11 und der Anschlussbereich 106 bzw. die externe Anschlussfläche 16, können lithographisch, insbesondere photolithographisch, unter Einsatz einer gemeinsamen Maske auf den Anschlussträger(verbund) 12 (100) aufgebracht, insbesondere abgeschieden, werden. Um die Stromträgfähigkeit zu erhöhen können die genannten Elemente galvanisch verstärkt werden.

Eine laterale Ladungsträgerverteilung um den Halbleiterkörper herum ist insbesondere für Halbleiterkörper zweckmäßig, die zur Erzeugung einer hohen Strahlungsleistung ausgebildet sind.

Der Halbleiterkörper kann zur Erzeugung einer Strahlungsleistung von 1W oder mehr ausgebildet sein. Der Halbleiterkörper kann eine Längsabmessung, z. B. eine Länge von 1 mm oder, bevorzugt von 2 mm oder mehr, und/oder eine Querabmessung, z. B. eine Breite, von 1 mm oder mehr, bevorzugt von 2 mm oder mehr, aufweisen. Derartig flächige Halbleiterkörper sind zur Erzeugung hoher Strahlungsleistungen besonders geeignet.

Figur 13 zeigt ein weiteres Ausführungsbeispiel eines optoelektronischen Bauelements anhand einer schematischen Schnittansicht.

Das Bauelement 10 entspricht im Wesentlichen den im Zusammenhang mit den vorhergehenden Figuren beschriebenen Bauelementen und kann insbesondere mittels eines der oben beschriebenen Verfahren, z. B. dem Verfahren gemäß Figur 3, hergestellt sein.

Im Unterschied zu den oben beschriebenen Bauelementen sind auf dem Halbleiterkörper 4 zwei elektrisch leitende Kontaktschichten 9, 50 angeordnet. Die Kontaktschichten, z. B. jeweils als Kontaktmetallisierung ausgeführt, sind auf der gleichen Seite des Halbleiterkörpers und insbesondere auf der dem Anschlussträger 12 zugewandten Seite des Halbleiterkörpers 4 angeordnet.

Die Kontaktschichten sind mit dem Halbleiterkörper 4 auf verschiedenen Seiten des aktiven Bereichs 5 verbunden. Die Kontaktschicht 9 kann mit der Halbleiterschicht 6 und die Kontaktschicht 50 mit der Halbleiterschicht 7 elektrisch leitend verbunden sein.

Weiterhin ist eine der beiden Kontaktschichten zugewandte Oberfläche 51 des Halbleiterkörpers bevorzugt bereichsweise zwischen beiden Kontaktschichten 9, 50 und dem aktiven Bereich 5 angeordnet. Die Kontaktschichten können sich insbesondere über eine gemeinsame Oberfläche des Halbleiterkörpers 4, z. B. die Oberfläche 51 des Halbleiterkörpers 4, erstrecken. Die Spiegelschicht 8 kann zwischen beiden Kontaktschichten und dem Halbleiterkörper angeordnet sein.

Seitens der Oberfläche 51 sind die Kontaktschichten zur Vermeidung eines Kurzschlusses zweckmäßigerweise elektrisch voneinander isoliert. Hierzu ist zweckmäßigerweise eine elektrische Isolationsschicht 52, z. B. ein Siliziumnitrid, ein Siliziumoxid oder ein Siliziumoxinitrid enthaltend, zwischen dem Halbleiterkörper 4 und der Kontaktschicht 50 angeordnet.

Im aktiven Bereich 5 kann, z. B. mittels einer Ausnehmung im Halbleiterkörper, eine Aussparung 53 ausgebildet sein. Durch die Aussparung 53 kann die Kontaktschicht 50 elektrisch leitend mit der von den Kontaktschichten abgewandten Seite des Halbleiterkörpers elektrisch leitend verbunden sein. In der Aussparung ist zweckmäßigerweise ein Durchkontakt 54 angeordnet, über den die Kontaktschicht 50 mit der Halbleiterschicht 7 des Halbleiterkörpers verbunden ist. Der Durchkontakt 54, z. B. ein Metallkontakt, kann sich von der Kontaktschicht 50 bis zur Halbleiterschicht 7 erstrecken. Zweckmäßigerweise ist der Durchkontakt im Bereich der Aussparung über ein Isolationsmaterial, z. B. die Isolationsschicht 52, elektrisch vom aktiven Bereich isoliert. Für die Kontaktbildung des Durchkontakts zum Halbleiterkörper kann die Isolationsschicht 52 geöffnet sein.

Die Halbleiterkörper können mit einer derartigen Kontaktführung auf dem Halbleiterkörperträger, insbesondere dem Aufwachssubstrat, bereitgestellt werden.

Die Kontaktschichten 9, 50 sind, zweckmäßigerweise über eine Befestigungsschicht 2 bzw. 55, mit dem jeweiligen Anschlussbereich 104 bzw. 106 elektrisch leitend verbunden.
Die externen Anschlussflächen 15, 16 sind auf der vom Halbleiterkörper 4 abgewandten Seite des Anschlussträgers ausgebildet und insbesondere über Verbindungsleiter 22, die sich durch den Trägerkörper 18 erstrecken elektrisch leitend mit dem jeweiligen Anschlussbereich 104, 106 verbunden.

Weiterhin sind Anschlussleiterschichten 1, 56 des jeweiligen Anschlussbereichs 104 bzw. 106 vorgesehen. Diese erstrecken sich vorzugsweise lateral vom Halbleiterkörper weg und sind lateral neben dem Halbleiterkörper elektrisch leitend mit den Anschlussflächen 15, 16, z. B. über die Verbindungsleiter 22, verbunden.

Der Abstand zwischen den Anschlussflächen 15, 16 ist bevorzugt größer als der Abstand zwischen den Kontaktschichten 9, 50 und/oder größer als der Abstand zwischen den Anschlussbereichen 104, 106.

Die Kontaktierung des Bauelements, z. B. durch Verlöten der Anschlussflächen mit den Leiterbahnen einer Leiterplatte, wird so vereinfacht, da der Abstand der Anschlussflächen gegenüber dem Abstand der Kontaktschichten, der im Wesentlichen von der Abmessung des Halbleiterkörpers bestimmt wird, im Wesentlichen frei gewählt werden kann.

Mittels der vorgeschlagenen Verfahren können nicht nur optoelektronische Halbleiterkörper verbundmäßig auf einen Anschlussträgerverbund übertragen werden. Vielmehr kann auch eine elektronische Komponente, z. B. zur Ansteuerung eines oder einer Mehrzahl von Halbleiterkörpern in einem Bauelementbereich auf dem Anschlussträgerverbund, wie etwa ein Halbleiterchip, zum Beispiel ein Steuerungschip und insbesondere ein IC-Chip, befestigt und elektrisch leitend mit dem(den) Halbleiterkörper(n) verbunden werden. Zweckmäßigerweise wird hierzu ein Komponentenverbund mit einer Mehrzahl gesonderter elektronischer Komponenten eingesetzt. Verschiedene Komponenten können in verschiedene Bauelementbereiche überträgen werden.

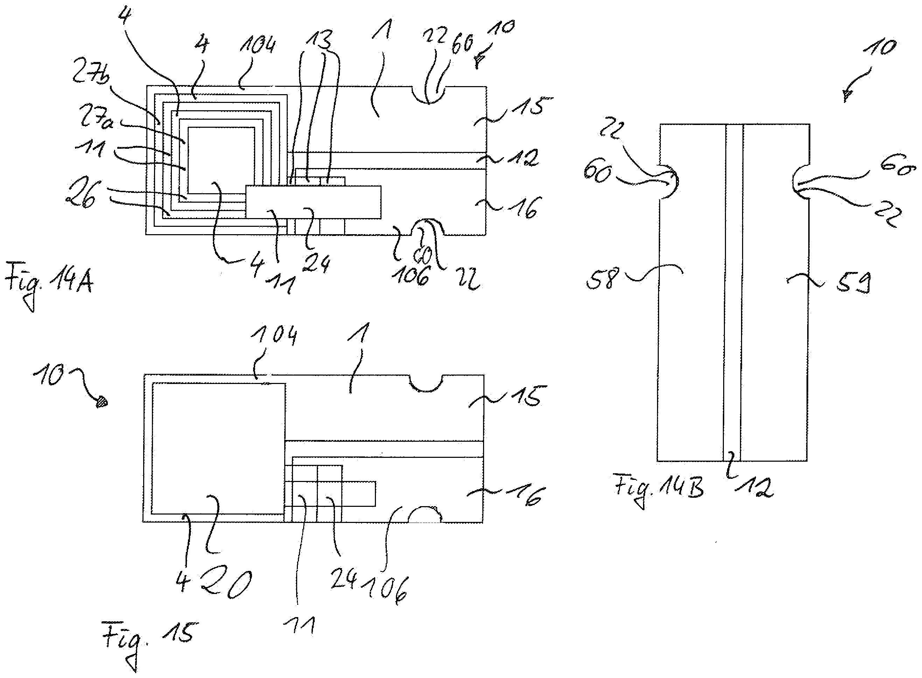

Figur 14 zeigt ein weiteres Ausführungsbeispiel eines optoelektronischen Bauelements 10 anhand zweier schematischer Aufsichten in den Figuren 14A und 14B. Figur 14A zeigt eine Aufsicht auf die Seite des Anschlussträgers 12, auf der der Halbleiterkörper 4 des Bauelements angeordnet ist. Figur 14B zeigt eine Aufsicht auf die von dem Halbleiterkörper 4 abgewandte Seite des Anschlussträgers 12.

Das Bauelement 10 gemäß diesem Ausführungsbeispiel entspricht im Wesentlichen den im Zusammenhang mit den vorhergehenden Figuren beschriebenen Bauelementen, insbesondere dem im Zusammenhang mit Figur 6 beschriebenen Bauelement.

Der Halbleiterkörper 4 ist auf dem Anschlussbereich 104 angeordnet und die dem Anschlussträger 12 zugewandte Seite des Halbleiterkörpers 4 ist elektrisch leitend mit dem Anschlussbereich 104 des Anschlussträgers 12 verbunden. Die Anschlussleiterschicht 1 erstreckt sich in Aufsicht auf den Halbleiterkörper 4 gesehen von dem Halbleiterkörper 4 weg. Die Anschlussleiterschicht 1 ist mit dem Anschlussbereich 104 elektrisch leitend verbunden und/oder die Anschlussleiterschicht 1 ist im Anschlussbereich 104 vorgesehen. Die Anschlussleiterschicht 1 ist mit einer Anschlussfläche 15 des Anschlussträgers elektrisch leitend verbunden. Die Anschlussfläche 15 ist auf der dem Halbleiterkörper 4 zugewandten Seite des Anschlussträgers 12 angeordnet.

Die vom Anschlussträger 12 abgewandte Seite des Halbleiterkörpers 4 ist mit dem Anschlussbereich 106 des Anschlussträgers elektrisch leitend verbunden. Der Anschlussbereich 106 kann die Anschlussfläche 16 aufweisen oder elektrisch leitend, zum Beispiel über eine weitere Anschlussleiterschicht analog zur Verbindung zwischen Anschlussfläche 15 und Anschlussbereich 104, mit dem Anschlussbereich 106 verbunden sein. Die Anschlussfläche 16 ist auf der dem Halbleiterkörper 4 zugewandten Oberfläche (Seite) des Anschlussträgers 12 angeordnet. Die Anschlussflächen 15, 16 sind auf der gleichen Seite des Anschlussträgers 12 angeordnet. Die Anschlussflächen 15, 16 sind auf verschiedenen Seiten des aktiven Bereichs (in Figur 14 nicht explizit gezeigt, vergleiche die weiter oben beschriebenen Figuren) und insbesondere auf verschiedenen Seiten des Halbleiterkörpers elektrisch leitend mit dem Halbleiterkörper 4 verbunden. Die Anschlussfläche 15 kann auf der dem Anschlussträger 12 zugewandten Seite des Halbleiterkörpers 4 elektrisch leitend mit dem Halbleiterkörper verbunden sein. Die Anschlussfläche 16 kann auf der vom Anschlussträger abgewandten Seite des Halbleiterkörpers 4 elektrisch leitend mit dem Halbleiterkörper verbunden sein.

Die Anschlussflächen 15, 16 können auf gleicher Höhe angeordnet sein.

Der Kontakt 11 erstreckt sich von der vom Anschlussträger 12 abgewandten Seite des Halbleiterkörpers 4 ausgehend in Richtung des Anschlussträgers 12 und ist elektrisch leitend mit dem Anschlussbereich 106 verbunden. Hierzu kann sich der Kontaktleiter 24, z. B. eine Schicht, wie etwa eine Gold-Schicht, entlang einer, beispielsweise keilartig ausgeführten, Kontaktrampe von der vom Anschlussträger abgewandten Seite des Halbleiterkörpers 4 bis zu und vorzugsweise über den Anschlussbereich 106 erstrecken. Die Kontaktrampe kann durch die Planarisierungsschicht 13 gebildet sein. Die Kontaktrampe verbreitert sich aufgrund der randseitigen Schräge 25 in Richtung des Anschlussträgers.

Die Kontaktrampe ist nur in einem Teilbereich neben einer Seitenfläche des Halbleiterkörpers 4 angeordnet. Insbesondere ist die Kontaktrampe auf dem Anschluss(leiter)bereich 106 angeordnet. Zweckmäßigerweise ist die Kontaktrampe zwischen dem Kontaktleiter und dem Anschluss(leiter)bereich 106 angeordnet. Die Kontaktrampe kann elektrisch isolierend ausgebildet sein und beispielsweise BCB enthalten. Der jeweilige Anschluss(leiter)bereich kann ein Metall, wie zum Beispiel Gold, oder eine Legierung mit einer Mehrzahl von Metallen enthalten.

Die Stromverteilungsstruktur 26 kann zwei Rahmen 27a und 27b aufweisen. Der Rahmen 27a verläuft in Aufsicht auf den Halbleiterkörper gesehen innerhalb des Rahmens 27b. Die Rahmen 27a, 27b können über den Kontaktleiter 24 elektrisch leitend miteinander verbunden sein. Der Kontaktleiter 24 kann sich über beide Rahmen 27a und 27b erstrecken. Alternativ oder ergänzend können die Rahmen und der Kontaktleiter eine gemeinsame Schicht aufweisen.

Der Anschlussbereich 104 ist mit einer Anschlussfläche 58 elektrisch leitend verbunden. Die Anschlussfläche 58 ist auf der von dem Halbleiterkörper 4 abgewandten Seite des Anschlussträgers 12 angeordnet. Der Anschlussbereich 104 und damit insbesondere der Halbleiterkörper kann mit zwei, auf verschiedenen Seiten des Anschlussträgers angeordneten Anschlussflächen 15,58 elektrisch leitend verbunden sein.

Der Anschlussbereich 106 ist mit einer Anschlussfläche 59 elektrisch leitend verbunden. Die Anschlussfläche 59 ist auf der von dem Halbleiterkörper 4 abgewandten Seite des Anschlussträgers 12 angeordnet. Der Anschlussbereich 106 und damit insbesondere der Halbleiterkörper kann mit zwei, auf verschiedenen Seiten des Anschlussträgers angeordneten Anschlussflächen 16, 59 elektrisch leitend verbunden sein.

Um diejenigen Anschlussflächen, die mit dem Halbleiterkörper auf der gleichen Seite des aktiven Bereichs elektrisch leitend verbunden sind, untereinander elektrisch leitend zu verbinden, kann sich (jeweils) ein Verbindungsleiter 22 von der dem Halbleiterkörper 4 zugewandten Seite des Anschlussträgers 12 zu der von dem Halbleiterkörper 4 abgewandten Seite des Anschlussträgers erstrecken. Die Verbindungsleiter 22 können die Anschlussflächen 15 und 58 bzw. 16 und 59 elektrisch leitend miteinander verbinden. Der jeweilige Verbindungsleiter 22 kann als Verbindungsleiterschicht, z. B. als metallhaltige Schicht, ausgebildet sein. Der (jeweilige) Verbindungsleiter kann sich entlang einer Seitenfläche des Anschlussträgers 12 erstrecken. Der (jeweilige) Verbindungsleiter 22 kann sich in einer, vorzugsweise randseitig im Anschlussträger 12 ausgebildeten, Aussparung (Via) 60 erstrecken.

Das Bauelement 10 kann insbesondere als SMD-Bauelement und/oder als nicht SMD-Bauelement kontaktiert werden (SMD: Surface Mountable Device, oberflächenmontierbares Bauelement)

Figur 15 zeigt ein weiteres Ausführungsbeispiel eines optoelektronischen Bauelements 10 anhand einer schematischen Aufsicht. Das Bauelement 10 entspricht dem im Zusammenhang mit Figur 14 beschriebenen Bauelement. Im Unterschied hierzu ist auf dem Halbleiterkörper 4 und insbesondere auf dem Kontaktleiter 24 und/oder der Stromverteilungsstruktur ein, bevorzugt auf den Halbleiterkörper lokalisiertes und/oder ein auf den Halbleiterkörper begrenztes, Lumineszenzkonversionselement 20, zum Beispiel eine Lumineszenzkonversionsschicht, wie etwa eine Leuchtstoffschicht angeordnet (vergleiche hierzu die Beschreibung weiter oben).

In einer bevorzugten Ausgestaltung enthält der (jeweilige) Halbleiterkörper im Rahmen der Anmeldung, insbesondere der aktive Bereich 5, die Schicht 6 und/oder die Schicht 7, ein III-V-Halbleitermaterial. Mittels III-V-Verbindungshalbleitermaterialien, insbesondere Nitrid-Verbindungshalbleitermaterialien, Phosphid-Verbindungshalbleitermaterialien oder Arsenid-Verbindungshalbleitermaterialien, können bei der Strahlungserzeugung vereinfacht hohe interne Quanteneffizienzen bei der Umwandlung von elektrischer Leistung in Strahlungsleistung erzielt werden. Bevorzugt basiert der aktive Bereich und insbesondere der jeweilige Halbleiterkörper daher auf einem der genannten Materialsysteme.

"Auf Phosphid-Verbindungshalbleitern basierend" bedeutet in diesem Zusammenhang, dass der aktive Bereich, insbesondere der Halbleiterkörper, vorzugsweise AlnGamIn1-n-mP umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Nitrid-Verbindungshalbleitern basierend" bedeutet in diesem Zusammenhang, dass der aktive Bereich, insbesondere der Halbleiterkörper, vorzugsweise AlnGamIn1-n-mN umfasst oder daraus besteht, wobei 0 ≤ n ≤ 1, 0 ≤ m ≤ 1 und n+m ≤ 1 ist, vorzugsweise mit n ≠ 0, n ≤ 1, m ≤ 0 und/oder m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Arsenid-Verbindungshalbleitern basierend" bedeutet in diesem Zusammenhang, dass der aktive Bereich, insbesondere der Halbleiterkörper, vorzugsweise AlnGamIn1-n-mAs umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

Als Aufwachssubstrat sind für Nitrid-Verbindungshalbleiter z. B. Saphir-, SiC- oder GaN-Aufwachssubstrate, für Phosphid- und Arsenid-Verbindungshalbleiter ist beispielsweise ein GaAs-Aufwachssubstrat geeignet.
Bevorzugt ist der (jeweilige) Halbleiterkörper zur Erzeugung von Strahlung im sichtbaren Spektralbereich ausgebildet. Weiterhin ist der jeweilige Halbleiterkörper bevorzugt zur Erzeugung inkohärenter Strahlung, insbesondere als LED-Halbleiterkörper, ausgebildet.
Nitrid- und Phosphid-Verbindungshalbleitermaterialien sind für die Erzeugung sichtbarer Strahlung besonders geeignet. Arsenid-Verbindungshalbleitermaterialien sind für den infraroten Spektralbereich besonders geeignet.
Nitrid-Verbindungshalbleitermaterialien eignen sich dabei besonders für die Erzeugung von Strahlung vom ultravioletten über den blauen bis in den grünen Spektralbereich und Phosphid-Verbindungshalbleitermaterialien für Strahlung vom orangen bis in den roten Spektralbereich.
Die vorliegende Patentanmeldung beansprucht die Priorität der deutschen Patentanmeldung DE 10 2007 030 129.6 vom 29. Juni 2007.

## Patentansprüche

1. Verfahren zur Herstellung einer Mehrzahl optoelektronischer Bauelemente mit den Schritten:
- Bereitstellen eines Anschlussträgerverbunds, der eine Mehrzahl von Bauelementbereichen aufweist, wobei in den Bauelementbereichen jeweils zumindest ein elektrischer Anschlussbereich vorgesehen ist,
- Bereitstellen eines Halbleiterkörperträgers, auf dem eine Mehrzahl gesonderter und mit dem Halbleiterkörperträger verbundener Halbleiterkörper angeordnet ist, wobei die Halbleiterkörper jeweils eine Halbleiterschichtenfolge mit einem aktiven Bereich aufweisen,
- Anordnen des Anschlussträgerverbunds und des Halbleiterkörperträgers relativ zueinander derart, dass die Halbleiterkörper den Bauelementbereichen zugewandt sind,
- mechanisches Verbinden einer Mehrzahl von Halbleiterkörpern mit dem Anschlussträgerverbund in einem Montagebereich eines dem jeweiligen Halbleiterkörper zugeordneten Bauelementbereichs, elektrisch leitendes Verbinden des jeweiligen Halbleiterkörpers mit dem Anschlussbereich des dem Halbleiterkörper zugeordneten Bauelementbereichs und Trennen der mit dem Anschlussträgerverbund zu verbindenden oder verbundenen Halbleiterkörper vom Halbleiterkörperträger,
- Aufteilen des Anschlussträgerverbundes in eine Mehrzahl von gesonderten optoelektronischen Bauelementen, die jeweils einen Anschlussträger, der den Bauelementbereich aufweist, und einen auf dem Anschlussträger angeordneten und mit dem Anschlussbereich elektrisch leitend verbundenen Halbleiterkörper aufweisen,
**gekennzeichnet dadurch, dass**
- ein Kontaktleiter ausgebildet wird, der sich von der vom Montagebereich abgewandten Seite des jeweiligen Halbleiterkörpers zum Anschlussträger hin erstreckt,
- wobei nach dem Befestigen der Halbleiterkörper auf dem Anschlussträgerverbund und noch vor dem Aufteilen des Anschlussträgerverbunds ein Kontakt auf die von dem Montagebereich abgewandte Seite des jeweiligen Halbleiterkörpers aufgebracht wird, wobei der Kontakt eine Stromverteilungsstruktur aufweist, die auf die von dem Montagebereich des Halbleiterkörpers abgewandte Seite des Halbleiterkörpers aufgebracht wird und der Kontaktleiter und die Stromverteilungsstruktur mittels Lithographie unter Verwendung einer gemeinsamen Maske auf den Anschlussträgerverbund aufgebracht werden, und
- wobei die Stromverteilungsstruktur und der Kontaktleiter eine durchgehende Schicht aufweisen.

2. Verfahren nach Anspruch 1,
bei dem der jeweilige Anschlussbereich den Montagebereich und einen Anschlussleiterbereich aufweist und sich der Montagebereich über den Anschlussleiterbereich erhebt.

3. Verfahren nach mindestens einem der vorhergehenden Ansprüche,
bei dem der Anschlussträger für im Halbleiterkörper erzeugte Strahlung durchlässig ist.

4. Verfahren nach mindestens einem der vorhergehenden Ansprüche,
bei dem die Anschlussbereiche des Anschlussträgerverbundes mittels Lithographie ausgebildet werden.

5. Verfahren nach mindestens einem der vorhergehenden Ansprüche,
bei dem in einem Bauelementbereich eine Mehrzahl von Halbleiterkörpern mit dem Anschlussträgerverbund verbunden wird und ein Abstand benachbarter Halbleiterkörper im Bauelementbereich 40 µm oder weniger beträgt.

6. Verfahren nach mindestens einem der vorhergehenden Ansprüche,
bei dem nach dem Befestigen der Halbleiterkörper auf dem Anschlussträgerverbund ein Planarisierungsmaterial zwischen
die Halbleiterkörper auf den Anschlussträgerverbund aufgebracht wird und das Planarisierungsmaterial, insbesondere nach dem Aufbringen, derart ausgebildet wird, dass neben dem jeweiligen Halbleiterkörper eine Planarisierungsschicht angeordnet ist.

7. Verfahren nach mindestens einem der vorhergehenden Ansprüche,
bei dem der Kontaktleiter schichtartig ausgebildet wird..

8. Verfahren nach mindestens einem der vorhergehenden Ansprüche,
bei dem der Halbleiterkörperträger nach dem Trennen der Halbleiterkörper vom Halbleiterkörperträger entfernt wird und ein weiterer Halbleiterkörperträger bereitgestellt wird, wobei Halbleiterkörper, die auf dem weiteren Halbleiterkörperträger angeordnet sind, mit dem Anschlussträgerverbund verbunden und vom weiteren Halbleiterkörperträger getrennt werden und wobei Halbleiterkörper, die auf dem weiteren Halbleiterkörperträger angeordnet sind, jeweils auf einem bereits mit dem Anschlussträgerverbund verbundenen Halbleiterkörper befestigt und insbesondere elektrisch leitend mit dem letzteren Halbleiterkörper verbunden werden.

9. Optoelektronisches Bauelement mit
- einem Halbleiterkörper, der eine Halbleiterschichtenfolge mit einem aktiven Bereich umfasst, und
- einem Anschlussträger, auf dem der Halbleiterkörper angeordnet und befestigt ist, wobei auf der dem Halbleiterkörper zugewandten Seite des Anschlussträgers ein elektrischer Anschlussbereich ausgebildet ist, der Anschlussbereich sich in Aufsicht auf den Anschlussträger neben dem Halbleiterkörper erstreckt und der Anschlussbereich mit dem Halbleiterkörper elektrisch leitend verbunden ist, **dadurch gekennzeichnet, dass**
eine Planarisierungsschicht neben dem Halbleiterkörper auf dem Anschlussträger angeordnet ist, wobei ein Abstand der vom Anschlussträger abgewandten Seite der Planarisierungsschicht von der dem Anschlussträger abgewandten Seite des Halbleiterkörpers geringer ist als ein Abstand der vom Anschlussträger abgewandten Seite des Halbleiterkörpers von dem Anschlussträger, bei dem sich ein mit der vom Anschlussträger abgewandten Seite des Halbleiterkörpers elektrisch leitend verbundener Kontaktleiter über die von dem Anschlussträger abgewandte Seite der Planarisierungsschicht erstreckt, wobei die Planarisierungsschicht auf einer vom Halbleiterkörper abgewandten Seite schräg zum Anschlussträger verläuft und sich der Kontaktleiter entlang der Schräge erstreckt, wobei das Bauelement eine Stromverteilungsstruktur aufweist, die auf einer vom Halbleiterkörper abgewandten Seite angeordnet ist, wobei die Stromverteilungsstruktur und der Kontaktleiter eine durchgehende Schicht aufweisen.

10. Bauelement nach Anspruch 9
bei dem zumindest eine externe Anschlussfläche des Bauelements auf der vom Halbleiterkörper abgewandten Seite des Anschlussträgers angeordnet ist und der Anschlussträger für die elektrisch leitende Anbindung der Anschlussfläche an den Halbleiterkörper ausgespart ist.

11. Bauelement nach einem der Ansprüche 9 bis 10,
bei dem der Halbleiterkörper eine Dicke von 10 µm oder weniger aufweist.

12. Bauelement nach einem der Ansprüche 9 bis 11,
das eine Mehrzahl von Halbleiterkörpern aufweist, wobei die aktiven Bereiche zweier Halbleiterkörper zur Erzeugung von Strahlung in verschiedenfarbigen Spektralbereichen ausgebildet sind.

13. Bauelement nach einem der Ansprüche 9 bis 12,
wobei die Planarisierungsschicht eine keilförmig ausgebildete Kontaktrampe bildet.

## Claims

1. A method for producing a plurality of optoelectronic components comprising the following steps:
- Providing a connection carrier assembly having a plurality of component regions, wherein at least one electrical connection region is provided in each of the component regions,
- Providing a semiconductor body carrier on which a plurality of separate semiconductor bodies connected to the semiconductor body carrier are arranged, wherein the semiconductor bodies each have a semiconductor layer sequence having an active region,
- Arranging the connection carrier assembly and the semiconductor body carrier relative to one another such that the semiconductor bodies face the component regions,
- Mechanically connecting a plurality of semiconductor bodies to the connection carrier assembly in a mounting region of a component region associated with the respective semiconductor body, electrically conductively connecting the respective semiconductor body to the connection region of the component region associated with the semiconductor body, and separating the semiconductor bodies to be connected to or connected to the connection carrier assembly from the semiconductor body carrier,
- Dividing the connection carrier assembly into a plurality of separate optoelectronic components, each of which comprises a connection carrier, which has the component region, and a semiconductor body which is arranged on the connection carrier and is electrically conductively connected to the connection region, **characterized in that**
- a contact conductor is formed which extends from the side of the respective semiconductor body facing away from the mounting region to the connection carrier,
- wherein, after the semiconductor bodies have been fastened on the connection carrier assembly and before the connection carrier assembly is divided up, a contact is applied to the side of the respective semiconductor body facing away from the mounting region, wherein the contact has a current distribution structure, which is applied to the side of the semiconductor body which faces away from the mounting region of the semiconductor body, and the contact conductor and the current distribution structure are applied to the connection carrier assembly by means of lithography using a common mask, and
- wherein the current distribution structure and the contact conductor have a continuous layer.

2. A method according to claim 1,
in which the respective connection region has the mounting region and a connection conductor region, and the mounting region rises above the connection conductor region.

3. The method according to at least one of the preceding claims,
in which the connection carrier is transmissive to radiation generated in the semiconductor body.

4. The method according to at least one of the preceding claims,
in which the connection regions of the connection carrier assembly are formed by means of lithography.

5. The method according to at least one of the preceding claims,
in which a plurality of semiconductor bodies is connected to the connection carrier assembly in a component region and a distance between adjacent semiconductor bodies in the component region is 40 µm or less.

6. The method according to at least one of the preceding claims,
in which, after the semiconductor bodies have been fastened on the connection carrier assembly, a planarization material is applied between the semiconductor bodies onto the connection carrier assembly, and the planarization material, in particular after application, is embodied in such a way that a planarization layer is arranged next to the respective semiconductor body.

7. The method according to at least one of the preceding claims,
in which the contact conductor is formed in a layer-like manner.

8. The method according to at least one of the preceding claims,
in which the semiconductor body carrier is removed after the semiconductor bodies have been separated from the semiconductor body carrier, and a further semiconductor body carrier is provided, wherein semiconductor bodies which are arranged on the further semiconductor body carrier are connected to the connection carrier assembly and separated from the further semiconductor body carrier, and wherein semiconductor bodies which are arranged on the further semiconductor body carrier are connected in each case on a semiconductor body which is already connected to the connection carrier assembly, and in particular are electrically conductively connected to the latter semiconductor body.

9. An optoelectronic component having
- a semiconductor body which comprises a semiconductor layer sequence having an active region, and
- a connection carrier on which the semiconductor body is arranged and fastened, wherein an electrical connection region is formed on the side of the connection carrier facing the semiconductor body, the connection region extends in plan view onto the connection carrier alongside the semiconductor body and the connection region is electrically conductively connected to the semiconductor body,
**characterized in that**
a planarization layer is arranged next to the semiconductor body on the connection carrier, wherein a distance of the side of the planarization layer facing away from the connection carrier is smaller than a distance of the side of the semiconductor body facing away from the connection carrier, in which a contact conductor, which is electrically conductively connected to the side of the semiconductor body facing away from the connection carrier, extends over the side of the planarization layer facing away from the connection carrier, wherein the planarization layer runs obliquely to the connection carrier on a side facing away from the semiconductor body and the contact conductor extends along the inclination, wherein the component has a current distribution structure, which is arranged on a side facing away from the semiconductor body, wherein the current distribution structure and the contact conductor have a continuous layer.

10. The component according to claim 9,
in which at least one external connection area of the component is arranged on the side of the connection carrier facing away from the semiconductor body, and the connection carrier is cut out for the electrically conductive connection of the connection area to the semiconductor body.

11. The component according to one of claims 9 to 10,
in which the semiconductor body has a thickness of 10 µm or less.

12. The component according to one of claims 9 to 11,
which has a plurality of semiconductor bodies, wherein the active regions of two semiconductor bodies are designed to generate radiation in differently coloured spectral regions.

13. The component according to one of claims 9 to 12,
wherein the planarization layer forms a wedge-shaped contact ramp.

## Revendications

1. Procédé destiné à fabriquer une pluralité de composants optoélectroniques comprenant les étapes de :
- fournir un ensemble de supports de raccordement présentant une pluralité de zones de composants, à chaque fois, au moins une zone de raccordement électrique étant prévue dans les zones de composants,
- fournir un support de corps semi-conducteurs, sur lequel une pluralité de corps semi-conducteurs distincts et raccordés au support de corps semi-conducteurs est agencée, les corps semi-conducteurs présentant à chaque fois une succession de couches semi-conductrices avec une zone active,
- agencer l'ensemble des supports de raccordement et le support de corps semi-conducteurs l'un par rapport à l'autre de sorte à orienter les corps semi-conducteurs vers les zones de composants,
- relier mécaniquement une pluralité de corps semi-conducteurs à l'ensemble de supports de raccordement dans une zone de montage d'une zone de composants attribuée au respective corps semiconducteur, relier de manière électriquement conductrice le respective corps semi-conducteur à la zone de raccordement de la zone de composants attribuée au corps semi-conducteur et séparer les corps semiconducteurs à relier ou reliés à l'ensemble des supports de raccordement du support de corps semiconducteurs,
- diviser l'ensemble du support de raccordement en une pluralité de composants optoélectroniques distincts, qui présentent à chaque fois un support de raccordement, présentant la zone de composants, et un corps semiconducteur agencé sur le support de raccordement et relié de manière électriquement conductrice à la zone de raccordement,
**caractérisé en ce que**
- un conducteur de contact est formé lequel s'étend vers le support de raccordement depuis le côté du respective corps semiconducteur opposé à la zone de montage,
- un contact étant appliqué sur le côté de respective corps semi-conducteur opposé à la zone de montage après la fixation du corps semiconducteur sur l'ensemble des supports de raccordement et encore avant la division de l'ensemble du support de raccordement, le contact présentant une structure de distribution de courant, qui est appliquée sur le côté du corps semiconducteur opposé à la zone de montage du corps semiconducteur et le conducteur de contact et la structure de distribution de courant sont appliqués au moyen de la lithographie en utilisant un masque commun sur l'ensemble des supports de raccordement, et
- la structure de distribution de courant et le conducteur de contact présentant une couche continue.

2. Procédé selon la revendication 1, dans lequel la respective zone de raccordement présente la zone de montage et une zone de conducteur de raccordement, et la zone de montage s'élève au-dessus de la zone du conducteur de raccordement.

3. Procédé selon au moins l'une quelconque des revendications précédentes, dans lequel le support de raccordement est perméable pour un rayonnement généré dans le corps semi-conducteur.

4. Procédé selon au moins l'une quelconque des revendications précédentes, dans lequel les zones de raccordement de l'ensemble des supports de raccordement sont formées au moyen d'une lithographie.

5. Procédé selon au moins l'une quelconque des revendications précédentes, dans lequel une pluralité de corps semi-conducteurs est raccordée à l'ensemble de supports de raccordement dans une zone de composants et un espacement des corps semiconducteurs adjacents s'élève à 40 µm ou moins dans la zone des composants.

6. Procédé selon au moins l'une quelconque des revendications précédentes, dans lequel, après la fixation des corps semiconducteurs sur l'ensemble des supports de raccordement, un matériau de planarisation est appliqué entre les corps semiconducteurs sur l'ensemble des supports de raccordement et le matériau de planarisation se forme en particulier après l'application, de sorte qu'une couche de planarisation soit agencée à côté de respective corps de semi-conducteur.

7. Procédé selon au moins l'une quelconque des revendications précédentes, dans lequel le conducteur de contact est formé sous forme de couches.

8. Procédé selon au moins l'une quelconque des revendications précédentes, dans lequel le support de corps semiconducteurs est enlevé, après la séparation des corps semiconducteurs, du support de corps semi-conducteurs et un autre support de corps semi-conducteurs est fourni, les corps semiconducteurs, qui sont agencés sur l'autre support de corps semi-conducteurs, étant reliés à l'ensemble des supports de raccordement et séparés de l'autre support de corps semiconducteurs et les corps semiconducteurs qui sont agencés sur l'autre support de corps semiconducteurs, étant fixés à chaque fois sur un corps semi-conducteur déjà relié à un ensemble de supports de raccordement et en particulier relié de manière électriquement conductrice au dudit dernier corps semiconducteur.

9. Composant optoélectronique comprenant
- un corps semi-conducteur comprenant une succession de couches semi-conductrices avec une zone active, et
- un support de raccordement sur lequel le corps semi-conducteur est agencé et fixé, sur le côté tourné vers le corps semiconducteur du support de raccordement, une zone de raccordement électrique étant formée, la zone de raccordement, dans une vue de dessus du support de raccordement, s'étendant à côté de corps semi-conducteur et la zone de raccordement étant reliée au corps de semiconducteur de manière électriquement conductrice,
**caractérisé en ce qu'**une couche de planarisation est agencée à côté du corps semiconducteur sur le support de raccordement, un espacement du côté de la couche de planarisation opposé au support de raccordement du côté du corps semi-conducteur opposé au support de raccordement étant plus faible qu'un espacement du côté du corps semiconducteur opposé au support de raccordement du support de raccordement, dans lequel un conducteur de contact relié de manière électriquement conductrice au côté du corps semiconducteur opposé au support de raccordement s'étend sur le côté de la couche de planarisation opposé au support de raccordement, la couche de planarisation s'étendant de maniéré inclinée par rapport au support de raccordement sur un côté opposé du corps semi-conducteur et le conducteur de contact s'étendant le long de l'inclinaison, le composant présentant une structure de distribution de courant qui est agencée sur un côté opposé au corps semiconducteur, la structure de distribution de courant et le conducteur de contact présentant une couche continue.

10. Composant selon la revendication 9, dans lequel au moins une surface de raccordement externe du composant est agencée sur le côté du support de raccordement opposé au corps semiconducteur, et le support de raccordement est évidé pour le raccordement électriquement conducteur de la surface de raccordement au corps semiconducteur.

11. Composant selon l'une quelconque des revendications 9 à 10, dans lequel le corps semiconducteur présente une épaisseur de 10 µm ou moins.

12. Composant selon l'une quelconque des revendications 9 à 11, qui présente une pluralité de corps semiconducteurs, les zones actives de deux corps semiconducteurs étant conçues pour générer un rayonnement dans des domaines spectrales de couleurs différentes.

13. Composant selon l'une quelconque des revendications 9 à 12, la couche de planarisation formant une rampe de contact conçue en forme de cale.
